# EUROPÄISCHE PATENTANMELDUNG

(11) **EP 0 877 259 A2**
(43) Veröffentlichungstag der Anmeldung: **11.11.1998**
(21) Anmeldenummer: 98113912.4
(22) Anmeldetag: 18.05.1995
(51) Int. Cl.: G01R 1/073

(54) **Vorrichtung zum Prüfen einer Kontaktinsel und Leiterbahnen aufweisenden elektrischen Leiterplatte**

(30) Priorität: 20.05.1994 DE 44178115; 26.10.1994 DE 44383169
(62) Teilanmeldung aus: 95920838.0
(71) Anmelder: Luther & Maelzer GmbH, D-31515 Wunstorf (DE)
(72) Erfinder: Dehmel, Rüdiger, 31515 Wunstorf (DE); Kassbaum, Torsten, 31515 Wunstorf (DE); Bruchwald, Edward, Dr., 31515 Wunstorf (DE)
(74) Vertreter: Schmidt-Evers, Jürgen, Dipl.-Ing.

(57) **Zusammenfassung**

Die Erfindung bezieht sich auf eine Vorrichtung (3) zum Prüfen einer Prüfpunkte bzw. Kontaktinseln (22a,22b) und Leiterbahnen aufweisenden elektrischen Leiterplatte (2), mit einem Prüfadapter (16, 17) mit Prüfstiften (33), die sich zwischen Prüfkontakten (39) eines Leiterplatten-Prüfgerätes (13) und den Kontaktinseln (22a, 22b) der zu prüfenden Leiterplatte (2) erstrecken, wobei eine Justiervorrichtung (21a, 21b) vorgesehen ist zum Justieren bzw. Feinverstellen der Prüfstifte (33) und/oder des Prüfadapters (16, 17) und/oder der Leiterplatte (2) quer zu den Prüfstiften (33) und zum Feststellen in der eingestellten Position.

## Beschreibung

Die Erfindung bezieht sich auf eine Vorrichtung zum Prüfen einer Kontaktinseln und Leiterbahnen aufweisenden elektrischen Leiterplatte nach dem Oberbegriff des Anspruchs 1.

Eine Vorrichtung dieser Art ist z.B. in der DE-OS 33 40 184 beschrieben.

Die mit der technischen Entwicklung zunehmende Verkleinerung der Leiterplatten bis auf eine Briefmarkengröße und kleiner bringt Probleme mit sich und zwar dadurch, daß die vorzugsweise nadelförmigen Prüfstifte ein Ziel im Bereich von 100 µm treffen müssen.

Es kann jedoch nicht garantiert werden, daß die Fixierelemente für einen Prüfadapter und/oder für eine Leiterplatte immer eine bestimmte reproduzierbare Ausrichtung zu dem Prüfpunktmuster der Leiterplatte haben. Schon geringfügige Abweichungen können dazu führen, daß das Prüfstiftmuster oder Prüfstiftspitzenmuster nicht mehr exakt auf das Prüfpunktmuster trifft. Die Abweichungen können ihre Ursache in erforderlichen Toleranzen, Fixierungsungenauigkeiten und/oder auch darin haben, daß das Prüfpunktmuster und die Fixierelemente in getrennten Arbeitsgängen hergestellt werden.

In der DE 43 02 509 A1 ist ein Verfahren zum Prüfen der korrekten Position einer Kontaktinseln und Leiterbahnen aufweisenden elektrischen Leiterplatte in einer Prüfvorrichtung beschrieben, bei dem eine Prüfanordnung verwendet wird, bei der in der korrekten Postition alle Kontaktinseln mit den zugehörigen Kontaktelementen mittig fluchtend zueinander ausgerichtet sind. Es wird die relative Position zwischen einer Leiterplatte und zugehörigen Prüfstiften in zwei verschiedenen Richtungen verändert, wobei in jeder dieser Richtungen wiederholt Messungen des Leitungszustands zwischen den Prüfstiften und den Prüfpunkten durchgeführt werden, um eine Position eines hochleitenden Zustands und zwei Positionen eines niedrigleitenden Zustands zu erfassen. Aus der so erhaltenen Information wird die gewünschte Verbindungsposition bestimmt, in der sich die Prüfstifte im höchsten Leitungszustand gegenüber den Prüfpunkten in einer oder in beiden Richtungen befinden. Dann werden die Prüfstifte relativ zur Leiterplatte bewegt, um die Prüfstifte in der gewünschten Verbindungs position anzuordnen.

Dieses bekannte Verfahren ist kompliziert, aufwendig und langwierig, da mehrere Bewegungsschritte und mehrere Messungen durchgeführt werden müssen, um Feststellen zu können, ob eine von der korrekten Position abweichende Positionsabweichung zwischen der Leiterplatte bzw. ihren Prüfpunkten und den Prüfstiften vorliegt, die so gering ist, daß sich der Zustand ,,gut" ergibt, oder so groß ist, daß sich der Zustand schlecht ergibt., und deshalb die Korrekturbewegung in die gewünschte Verbindungposition erfolgen soll, in der die weitere Prüfung der Leiterplatte stattfinden kann. Eine Vorrichtung zur Durchführung dieses bekannten Verfahrens ist in dieser Druckschrift nicht beschrieben.

Der Erfindung liegt die Aufgabe zugrunde, eine Vorrichtung oder ein System zum Prüfen einer elektrischen Leiterplatte so weiterzubilden, daß eine Sollposition zwischen dem Prüfstiftspitzenmuster und Prüfpunktmuster herbeiführbar ist.

Diese Aufgabe wird durch die Merkmale des Anspruchs 1 gelöst.

Bei der erfindungsgemäßen Vorrichtung bzw. dem erfindungsgemäßen System ist wenigstens eine Justiervorrichtung vorgesehen, die es gestattet, eine Sollposition zwischen dem einander zugehörigen Prüfstiftspitzenmuster und Prüfpunktmuster herbeizuführen. Dies läßt sich durch eine Relativverschiebung und Positionierung zwischen der Leiterplatte und dem Prüfstiftspitzenmuster bzw. den Prüfstiftspitzen und/oder dem zugehörigen Prüfadapter herbeiführen und zwar auf einer oder auf beiden Seiten der Leiterplatte. Dies kann durch eine Justierung des Prüfadapters, des Prüfstiftspitzenmusters und/oder des Prüfpunktmusters erfolgen, was mit der zugehörigen Justiervorrichtung mechanisch von Hand oder elektromechanisch automatisch ausgeführt werden kann.

Es ist vorteilhaft, mittels der Justiervorrichtung eine Justierung des Prüfstiftspitzenmusters bezüglich des zugehörigen Prüfpunktmusters durchzuführen, wobei die Prüfstiftspitzen in eine mit dem zugehörigen Prüfpunktmuster übereinstimmende Stellung verschoben und in der verschobenen Position festgestellt werden. Auf diese Weise ist es möglich, auf einer Seite oder zu beiden Seiten der Leiterplatte unabhängig voneinander eine Justierung durchzuführen. Um denkbare Unterschiede ausgleichen zu können, bedarf es translatorischer und/oder rotatorischer Bewegungsmöglichkeiten für den zu justierenden Gegenstand, bei der vorliegenden Ausgestaltung die Prüfstiftspitzen bzw. das Prüfstiftmuster. Hierzu kann eine Justierplatte dienen, durch die sich die Prüfstiftspitzen in passenden Löchern erstrecken und die translatorisch und rotatorisch verstellbar und in der jeweiligen Verstellposition feststellbar ist. Die Verstellung erfolgt unter Berücksichtigung des vorhandenen Unerschieds zwischen der Istposition des Prüfstiftspitzenmusters und des Prüfpunktmusters, wobei das Prüfstiftspitzenmuster mit der Justierplatte jeweils in eine mit dem Prüfpunktmuster im wesentlichen übereinstimmende Sollposition justiert wird.

Im weiteren bezieht sich die Erfindung gemäß Anspruch 20 auch auf einen Prüfadapter und gemäß Anspruch 21 auch auf eine Justiervorrichtung, jeweils für eine Vorrichtung zum Prüfen oder Bestücken einer Kontaktinseln und Leiterbahnen aufweisenden Leiterplatte, deren Merkmale die Aufgabe ebenfalls lösen.

Der Erfindung liegt unter einem anderen Aspekt die Aufgabe zugrunde, ein Verfahren zu finden, mit dem die Prüfung bzw. Feststellung der Position der Leiterplatte bzw. ihrer Kontaktinseln relativ zur Prüfvorrichtung einfacher durchgeführt werden kann.

Diese Aufgabe wird durch die Merkmale des Anspruchs 22 gelöst.

Gemäß Anspruch 22 bezieht sich die Erfindung auf ein Verfahren zum Prüfen (Feststellen) von Leiterplatten bezüglich der Position der Leiterplatte bzw. ihrer Prüfpunkte bzw. Kontkaktinseln relativ zu den Prüfstiften eines Prüfadapters. Bei diesem Verfahren erfolgt die Überprüfung der Position der Leiterplatte an einer besonderen Arbeitsstation, wobei die Leiterplatte optisch vermessen wird und Positionsabweichungen der Leiterplatte von der korrekten Position im Prüfgerät zum Prüfen der Prüfpunkte der Leiterplatte mittels einer Justiervorrichtung justiert werden. Das Prüfgerät ist einer besonderen Arbeitsstation zugeordnet, der die jeweilige Leiterplatte nach ihrer Vermessung zugeführt wird. Dabei erfolgt die Justierung in die gewünschte Position dadurch, daß die Prüfenden der Prüfstifte mittels der Justiervorrichtung verschoben werden.

Das der Erfindung zugrundeliegende Problem, nämlich eine hinreichend genaue Positionierung der Leiterplatte relativ zu wenigstens einem mit den Kontaktstellen bzw. Kontaktinseln der Leiterplatte in Verbindung bringbaren Element stellt sich auch bei der Bestückung einer Leiterplatte mit elektronischen Bauelementen mittels einer Bestückungsvorrichtung. Die erfindungsgemäße Vorrichtung bzw. System und das erfindungsgemäße Verfahren sind deshalb nicht nur bei einer Prüfvorrichtung für Leiterplatten sondern auch bei einer Bestückungsvorrichtung für Leiterplatten vorteilhaft anzuwenden. Je kleiner eine Leiterplatte konzipiert wird, desto kleiner sind auch die Kontaktinseln und die dazwischen vorhandenen Abstände. Deshalb besteht die Gefahr, daß bei einer ungenauen Bestückung der Leiterplatte, z.B. mit IC's, falsche Kontaktierungen und Kurzschlüsse eintreten können.

Die Erfindung ermöglicht in einfacher und sicherer Weise eine Einstellung bzw. Justierung dahingehend, daß dann, wenn eine unbefriedigende Kontaktierung der Kontaktinsel oder ein Nicht-Kontakt vorliegt, die Positionsabweichung bzw.-abweichungen durch eine Justierung in eine Position korrigiert werden, in der bei einer nachfolgenden Prüfung der Kontaktinseln der Leiterplatte ein sicherer Kontakt für die Kontaktelemente oder bei einer nachfolgenden Bestückung der Kontaktinseln mit elektronischen Bauelementen eine genaue Bestückung erreicht wird.

In den Unteransprüchen sind Merkmale enthalten, die die Feststellung der Positionsabweichungen und auch die Prüfung der Kontaktinseln der Leiterplatte weiter verbessern, zu stabilen und sicheren Funktionen führen und außerdem zu kleinen Bauweisen führen, wodurch die Feststellung der Positionsabweichung und auch die Prüfung der Kontaktinseln der Leiterplatte störungsfrei und sicher durchgeführt werden kann.

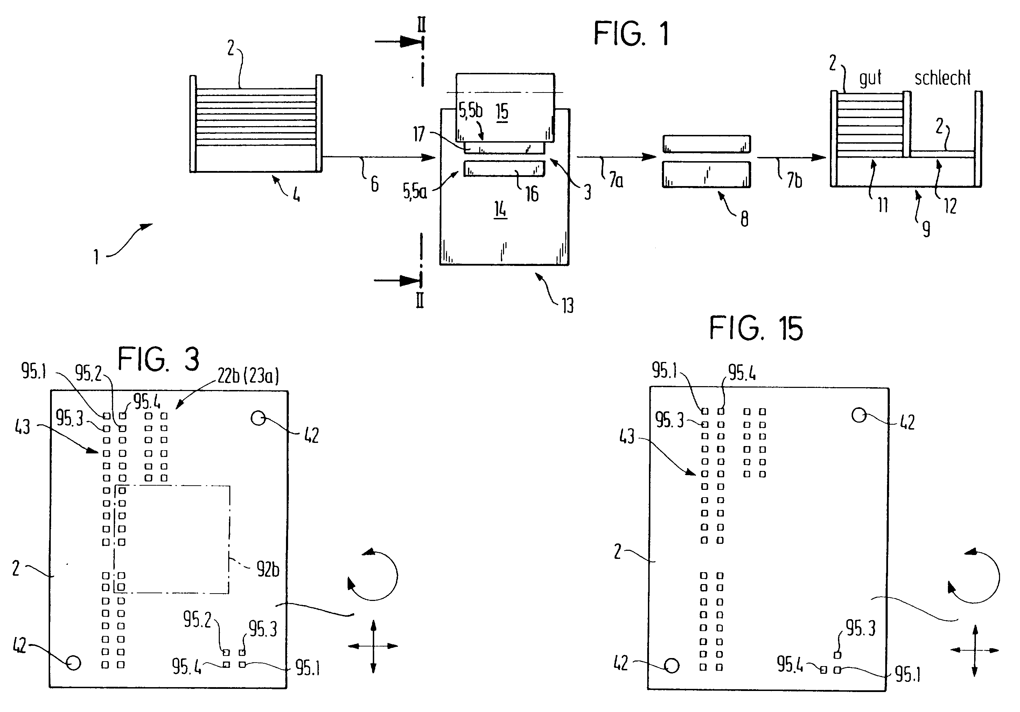

Nachfolgend werden die Erfindung und weitere durch sie erzielbare Vorteile anhand bevorzugter Ausführungsbeispiele und einer Zeichnung näher erläutert. Es zeigt
- Fig. 1: eine Anlage zum Justieren und Prüfen von elektrischen Leiterplatten in der Vorderansicht und in schematischer Darstellung;
- Fig. 2: eine in die Anlage integrierte Vorrichtung für den Justier- und Prüfvorgang in der Seitenansicht gemäß Schnitt II-II in Fig. 1;
- Fig. 3: eine zu prüfende Leiterplatte in der Draufsicht;
- Fig. 4: eine Justiereinrichtung für die erfindungsgemäße Vorrichtung in der Draufsicht;
- Fig. 5: eine Justiereinrichtung in abgewandelter Ausgestaltung für die erfindungsgemäße Vorrichtung;
- Fig. 6: eine weiter abgewandelte Justiereinrichtung in der Draufsicht;
- Fig. 7: den Teilschnitt VII-VII in Fig. 6;
- Fig. 8: die in Fig. 7 mit X gekennzeichneten Einzelheit in vergrößerter Darstellung;
- Fig. 9: eine weiter abgewandelte Justiereinrichtung in der Draufsicht;
- Fig. 10: ein Vorrichtung einer Feststell- oder Vermessungsvorrichtung zum Feststellen einer Positionsabweichung zwischen der zu prüfenden Leiterplatte und einem zugehörigen Prüfadapter als Einzelheit;
- Fig. 11: eine der Fig. 10 entsprechende Einzelheit in abgewandelter Ausgestaltung;
- Fig. 12: eine der Fig. 10 entsprechende Einzelheit in weiter abgewandelter Ausgestaltung;
- Fig. 13: die Einzelheit nach Fig. 12 in abgewandelter Ausgestaltung;
- Fig. 14: eine der Fig. 12 entsprechende Einzelheit in weiter abgewandelter Ausgestaltung;
- Fig. 15: eine Leiterplatte in abgewandelter Ausgestaltung;
- Fig. 16: eine Bestückungsvorrichtung zum Bestücken einer Leiterplatte mit elektronischen Bauelementen in der Vorderansicht, wobei in die Bestückungsvorrichtung ein erfindungsgemäßes Vorrichtung zur Prüfung der korrekten Position einer Leiterplatte oder zur Feststellung einer Abweichung von dieser korrekten Korrektion integriert ist;
- Fig. 17: eine Bestückungsvorrichtung in abgewandelter Ausgestaltung.

Die Hauptteile der Anlage 1 zum Prüfen von elektronischen Leiterplatten 2 sind eine allgemein mit 3 bezeichnete Prüfvorrichtung für die Leiterplatten 2, eine Entstapelungs- bzw. Vereinzelungsvorrichtung 4, eine Feststell- oder Vermessungsvorrichtung 5 für die Leiterplatten 2, eine Zuführungsvorrichtung 6 zum Zuführen der Leiterplatten 2 von der Vereinzelungsvorrichtung 4 zur Prüfvorrichtung 3, eine Abführungsvorrichtung 7a, 7b zum Abführen der Leiterplatten von der Prüfvorrichtung 3, wobei in die Abführungsvorrichtung 7a, 7b eine Kennzeichnungsvorrichtung 8, eine Sortiervorrichtung 9 und jeweils eine Stapelvorrichtung 11, 12 für die sortierten, d.h. guten und schlechten Leiterplatten 2 zugeordnet sein kann.

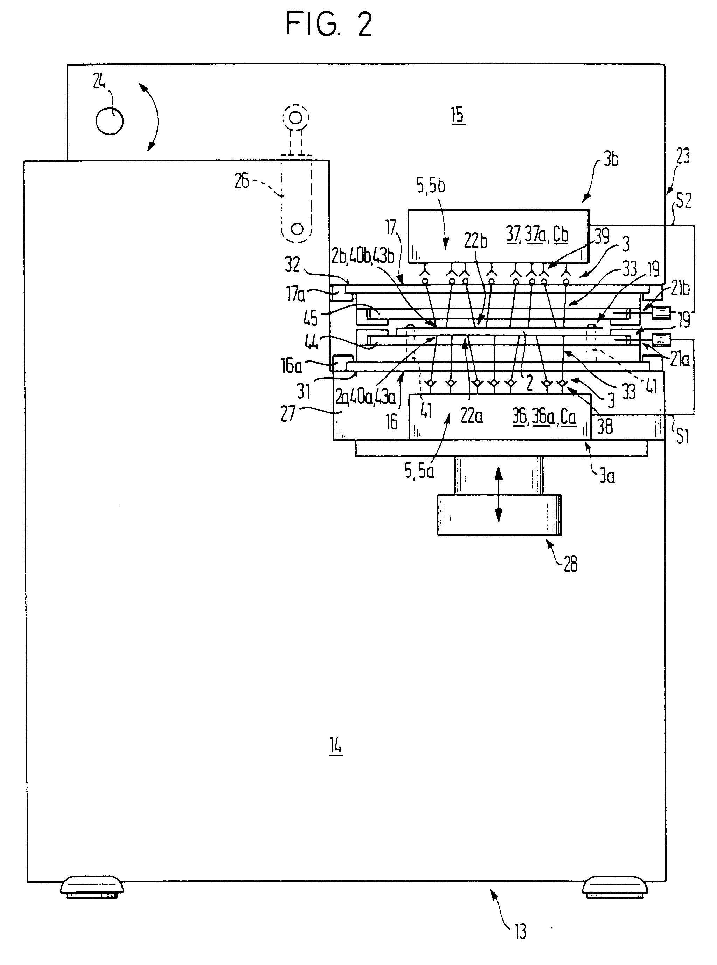

Die Hauptteile der in einem Prüfgerät 13 mit einem Geräteunterteil 14 und einem Geräteoberteil 15 angeordneten Prüfvorrichtung 3 sind zwei übereinander angeordnete Prüfadapter 16, 17, die in zueinander spiegelbildlicher Anordnung mittels Befestigungsvorrichtungen 16a, 16b am zugehörigen Unter- bzw. Oberteil 14, 15 befestigt sind, eine Positioniervorrichtung 19 für eine zu prüfende Leiterplatte 2 in beim vorliegenden Ausführungsbeispiel horizontaler Anordnung zwischen den Prüfadaptern 16, 17 und zwei Justiervorrichtungen 21a, 21b jeweils zum Einjustieren einer Soll-Position zwischen der Leiterplatte 2 und den Prüfadaptern 16, 17 (siehe Fig. 2), in der ein Kontakt gewährleistet ist.

Im Rahmen der Erfindung kann die Prüfvorrichtung 3 auch zum Prüfen der Leiterplatte 2 in einer anderen als horizontalen Position eingerichtet sein, z.B. in einer vertikalen Position. Im Gegensatz zur vorliegenden Ausgestaltung, bei der die Leiterplatte 2 beidseitig mit Prüfpunkten 22a, 22b versehen ist, kann die Prüfvorrichtung 3 zum Prüfen nur einer Seite der Leiterplatte 2 eingerichtet sein. Solche Prüfpunkte 22a, 22b, werden in der Fachsprache auch mit den Fachbegriffen Kontaktinseln oder pads bezeichnet.

Um die Einführung bzw. Abführung und Positionierung der Leiterplatte 2 in der Prüfvorrichtung 3 und ggf. das Vermessen der Leiterplatte 2 zu erleichtern, ist der Prüfadapter quer zur Leiterplatte 2 bzw. sind die Prüfadapter 16, 17 so weit voneinander distanzierbar, daß die Leiterplatte 2 dazwischen ein- und ausgeführt werden kann. Dies kann dadurch erreicht werden, daß das Geräteunterteil und/oder das Geräteoberteil 14, 15 verstellbar gelagert sind. Bei der vorliegenden Ausgestaltung übernimmt diese Funktion das Geräteoberteil 15, das in seinem der Bedienungs- bzw. Vorderseite 23 abgewandten, also hinteren Endbereich um eine horizontale, quer verlaufende Gelenkachse 24 zwischen der in Fig. 2 dargestellten Arbeitsstellung und einer nach oben verstellten Freigabestellung (nicht dargestellt) schwenkbar gelagert und durch einen Antrieb 26, hier ein Zylinderkolbenantrieb, hin und her verstellbar und in der jeweiligen Verstellposition feststellbar ist.

Somit ist sowohl dem Geräteunterteil 14 als auch dem Geräteoberteil 15 jeweils ein zugehöriger Prüfvorrichtungsteil 3a, 3b und eine eigenständige Feststell- oder Vermessungsvorrichtung 5a, 5b zugeordnet. Das obere Prüfvorrichtungsteil 3b ist in vorbeschriebener Weise aufwärts und abwärts beweglich angeordnet ist. Vorzugsweise ist aus besonderen Gründen in noch zu beschreibender Weise auch der untere Prüfvorrichtungsteil 3a vertikal verstellbar und in der jeweiligen Position feststellbar, was noch beschrieben wird. Hierzu dient ein vorzugsweise tischförmiger Träger 27, der durch eine Hubvorrichtung 28, z.B. eine pneumatische oder hydraulische Zylinderkolbeneinheit, vertikal verstellbar ist.

Das Geräteunterteil oder der Träger 27 und das Geräteoberteil 14, 15 weisen an ihrer Unterseite bzw. Oberseite ggf. ebene bzw. tischförmige Anlageflächen 31, 32 auf, an denen die Prüfadapter 16, 17 mittels den Befestigungsvorrichtungen 16a, 17a bei der vorliegenden Ausgestaltung starr jedoch lösbar befestigt sind.

Zu einem Prüfvorrichtungsteil 3a, 3b gehört jeweils der zugehörige Prüfadapter 16, 17 mit zugehörigen Prüfstiften 33, die den Prüfadapter 16, 17 in Durchgangslöchern 34 durchsetzen, wobei die vorzugsweise mit Kopfverdickungen, insbesondere Kugelköpfen 35, an ihren der Leiterplatte 2 abgewandten Enden versehenen Prüfstifte etwas länger bemessen sind als die Dicke der Prüfadapter 16, 17. Jedem Prüfvorrichtungsteil 3a, 3b ist ein Prüfmodul 36, 37 mit vorzugsweise kalottenförmigen Prüfkontakten 38, 39 zum Kontaktieren der Kopfenden der Prüfstifte 33 zugeordnet. Das obere Prüfmodul 36 befindet sich im schwenkbaren Geräteoberteil 15, und das untere Prüfmodul 36 am Geräteunterteil, hier auf bzw. im Träger 27. Die Prüfmodule 36, 37 sind durch nicht dargestellte Signal- und Steuerleitungen mit einer jeweils zugehörigen elektronischen Steuereinrichtung 36a, 37a verbunden, die in eine umfassende Steuereinrichtung der Prüfvorrichtung 3 integriert sind, die das Prüfen der Leiterplatte 2 ermöglicht und Anzeigeelemente für Fehler der Leiterplatte 2 aufweisen kann.

Beim Prüfen wird in üblicher Weise elektrischer Strom durch die Prüfstifte 33 geleitet.

Bei einer zweiseitigen Prüfung der Leiterplatte 2 sind zu deren beiden Seiten eine Prüfvorrichtung 3a, 3b und eine Feststell- oder Vermessungsvorrichtung 5a, 5b vorgesehen.

Es ist hervorzuheben, daß die Prüfvorrichtungsteile 3a, 3b und/oder die Prüfmodule 36, 37 und/oder die Feststell- oder Vermessungsvorrichtungen 5a, 5b prinzipiell gleich und einander spiegelbildlich gegenüberliegend ausgebildet und angeordnet sind, jedoch unterscheiden sie sich bezüglich bestimmter Maßnahmen zum Kontaktieren der Leiterplatte 2, was im weiteren noch beschrieben wird.

Während des Prüfens kontaktieren die Prüfstifte 33 mit ihren kegelförmig angespitzten Enden die Prüfpunkte 22a, 22b der Leiterplatte 2, die wenigstens teilweise außer Raster (of grid) angeordnet sein können. Da die Prüfkontakte 38, 39 der Prüfmodule 36, 37 sich im Raster (in grid) befinden, ist für wenigstens einen Teil der Prüfstifte 33 und der zugehörigen Durchgangslöcher 34 eine von der vertikalen Erstreckung abweichende schräge Erstreckung vorgegeben.

Zur Positionierung der Leiterplatte 2 mit der Positioniervorrichtung 19 in der Prüfvorrichtung 3 sind Positionierelemente vorgesehen, die zwischen der Leiterplatte 2 und der Prüfvorrichtung 3 wirksam sind. Bei der vorliegenden Ausgestaltung sind die Positionierelemente zwischen der Leiterplatte 2 und dem Geräteunterteil 14 wirksam, vorzugsweise zwischen der Leiterplatte 2 und dem unteren Prüfadapter 16, der vorzugsweise auf der insbesondere ebenen Oberseite des Geräteunterteils 14 oder des Trägers 27 aufliegt. Hierzu dienen beim vorliegenden Ausführungsbeispiel vorzugsweise zwei einen Abstand voneinander aufweisende Zentrierstifte 41 runden Querschnitts, auf die die Leiterplatte 2 mit zugehörigen Paßlöchern 42 aufsetzbar ist. Beim vorliegenden Ausführungsbeispiel sind die Zentrierstifte 41 fest im unteren Prüfadapter 16 angeordnet, wobei sie letzteren um ein etwa der Dicke der Leiterplatte 2 entsprechendes Maß überragen und an ihren freien Enden angespitzt oder gerundet sind, so daß die Leiterplatte 2 handhabungsfreundlich (Fangstifte) auf die Zentrierstifte 41 aufsetzbar ist.

Aufgrund der kleinen und vorzugsweise einander gleichen Abmessung der Prüfpunkte und des verhältnismäßig geringen Abstands der Prüfpunkte 22a, 22b voneinander bedarf es einer großen Genauigkeit bzw. Übereinstimmung zwischen dem Prüfstiftspitzenmuster 40a, 40b und dem zugehörigen Prüfpunktmuster 43a, 43b (pad-Muster), da anderenfalls die Gefahr von Fehlkontaktierungen besteht.

Es gibt jedoch mehrere Ursachen dafür, daß an der Prüfvorrichtung 3 Unterschiede bzw. Positionsabweichungen zwischen den Prüfstiftspitzenmustern 40a, 40b und den Prüfpunktmustern 43a, 43b bestehen. Diese Unterschiede können ihre Ursache in den vorhandenen Herstellungstoleranzen und/oder Befestigungsungenauigkeiten haben.

Bei der vorliegenden Ausgestaltung, bei der die Leiterplatten 2 mit ihren Paßlöchern 42 positioniert sind, kann eine vorbeschriebene Positionsabweichung z.B. dadurch verursacht sein, daß die Paßlöcher 42 bezüglich eines der beiden oder beider Prüfpunktmuster 43a, 43b auf der einen und/oder anderen Seite der Leiterplatte 2 nicht in der angestrebten Sollposition sondern in einer abweichenden Istposition stehen.

Um diesen Mangel zu beseitigen, ist wenigstens eine erfindungsgemäße Justiervorrichtung vorgesehen, die es gestattet, eine Sollposition zwischen den einander zugehörigen Prüfstiftspitzenmustern 40a, 40b und Prüfpunktmustern 43a, 43b herbeizuführen. Dies läßt sich durch eine Relativverschiebung und Positionierung zwischen der Leiterplatte 2 und den Prüfstiftspitzenmustern 40a, 40b bzw. den Prüfstiftspitzen und/oder den zugehörigen Prüfadaptern 16, 17 herbeiführen und zwar bei der vorliegenden Ausgestaltung auf beiden Seiten der Leiterplatte 2. Dies kann durch eine Justierung des oder der Prüfadapter 16, 17, des oder der Prüfstiftspitzenmuster 40a, 40b und/oder des oder der Prüfpunktmuster 43a, 43b erfolgen, was mit der zugehörigen Justiervorrichtung bzw. den Justiervorrichtungen 21a, 21b mechanisch von Hand oder elektromechanisch automatisch ausgeführt werden kann.

Es ist vorteilhaft, mittels der Justiervorrichtung 21a bzw. 21b eine Justierung des Prüfstiftspitzenmusters 40a bzw. 40b bezüglich des zugehörigen Prüfpunktmusters 43a bzw. 43b durchzuführen, wobei die Prüfstiftspitzen in eine mit dem zugehörigen Prüfpunktmuster 43a, 43b übereinstimmende Stellung verschoben und in der verschobenen Position festgestellt werden. Auf diese Weise ist es möglich, auf einer Seite oder zu beiden Seiten der Leiterplatte 2 unabhängig voneinander eine Justierung durchzuführen. Um denkbare Unterschiede ausgleichen zu können, bedarf es translatorischer und/oder rotatorischer Bewegungsmöglichkeiten für den zu justierenden Gegenstand, bei der vorliegenden Ausgestaltung die Prüfstiftspitzen bzw. das Prüfstiftmuster 43a, 43b. Hierzu dienen Justierplatten 44, 45, durch die sich die Prüfstiftspitzen in passenden Löchern erstrecken und die translatorisch und rotatorisch verstellbar und in der jeweiligen Verstellposition feststellbar sind. Die Verstellung erfolgt unter Berücksichtigung des vorhandenen Unterschieds zwischen der Istposition des Prüfstiftspitzenmusters 40a bzw. 40b und des Prüfpunktmusters 43a, 43b, wobei die Prüfstiftspitzenmuster mit den Justierplatten 44, 45 jeweils in eine mit den Prüfpunktmustern im wesentlichen übereinstimmende Sollposition justiert werden.

Die Steuerung der Justiervorrichtungen 21a, 21b erfolgt mittels den Feststell- oder Vermessungsvorrichtungen 5a, 5b zugeordneten elektrischen Schaltungen, die in die Steuereinrichtungen 36a, 37a integriert sind, und mittels nur in Fig. 2 dargestellten Steuerleitungen S1, S2 unter Berücksichtigung der von der zugehörigen Feststell- oder Vermessungsvorrichtung 5a, 5b ermittelten Positionsabweichung. Die Steuerleitungen S1, S2 sind mit den zugehörigen Verstellmotoren der Justiervorrichtung 21a, 21b verbunden.

Den Justiervorrichtungen 21a, 21b sind jeweils drei Verstellvorrichtungen 46a, 46b. 46c zugeordnet, mit denen das zu verstellende Teil, hier die zugehörige Justierplatte 44, 45 translatorisch und rotatorisch, d.h. in der Ebene der zugehörigen Justierplatte allseitig verstellbar und in der jeweiligen Verstellpostion feststellbar ist.

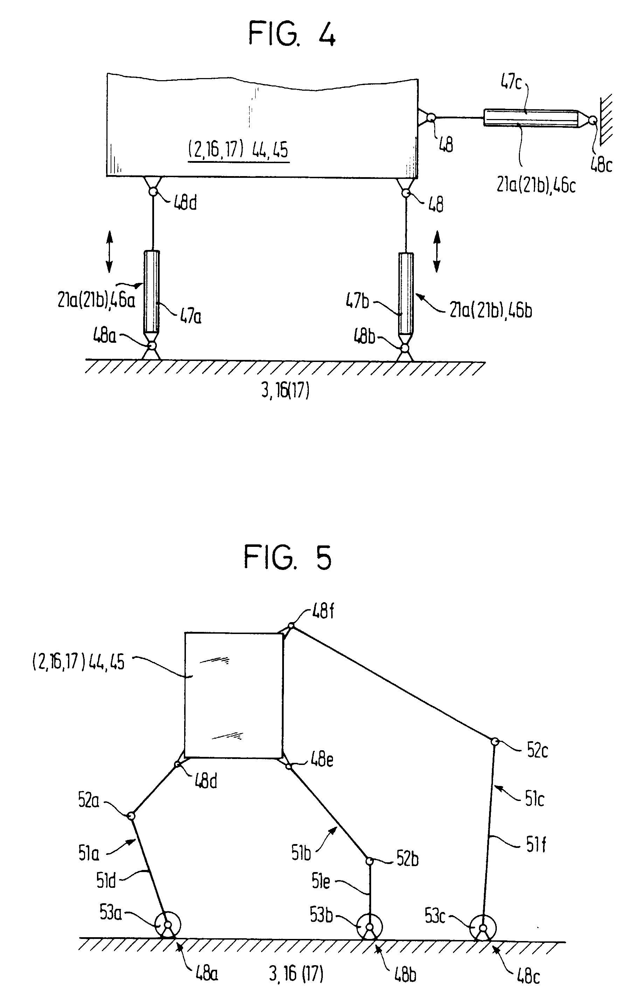

Bei der Ausgestaltung gemäß Fig. 4 sind die Verstellvorrichtungen 46a, 46b, 46c jeweils durch längenverstellbare Schub- und Zugstangen 47 gebildet, die wahlweise aus- und einfahrbar sind und in Gelenken 48a, 48b, 48c, 48d, 48e mit senkrecht zur Verstellebene verlaufenden Gelenkachsen schwenkbar an Teilen der Prüfvorrichtung 3, hier am zugehörigen Prüfadapter 16, 17 abgestützt sind und am zu verstellenden Teil, hier eine Justierplatte 44 oder 45, schwenkbar angreifen. Dabei kann die dritte Schub- und Zugstange 47c in einem gemeinsamen Gelenk (Doppelgelenk) mit der Schub- und Zugstange 47b angreifen, oder sie kann auch in einem Abstand von diesem Gelenk in einem eigenen Gelenk am zu verstellenden Teil angreifen. In der jeweiligen Verstellposition sind die Schub- und Zugstangen 47a, 47b, 47c jeweils gegen eine Längenverstellung gesperrt. Hierdurch ist das zu verstellende Teil in der jeweiligen Verstellpostion festgestellt.

Bei der Ausgestaltung gemäß Fig. 5 sind anstelle von längenveränderlichen Schub- und Zugstangen drei Kniehebelstangen 51a, 51b, 51c mit Kniegelenken 52a, 52b, 52c vorgesehen, wobei den Gelenken 48a, 48b, 48c Schwenkantriebe 53a, 53b, 53c zum Hin- und Herschwenken der ersten Kniehebelarme 51d, 51e, 51f zugeordnet sind, die durch Kreise verdeutlicht sind und in der nicht angetriebenen Position starr sind. Hierdurch ist das zu verstellende Teil in der jeweils verstellten Position festgestellt. Da es sich bei dem zu verstellenden Teil um einen der Prüfadapter 16, 17 oder um eine der Justierplatten 44, 45 oder um die Leiterplatte 2 handeln kann, sind die Bezugszeichen dieser Teile in den Fig. 4 und 5 angegeben.

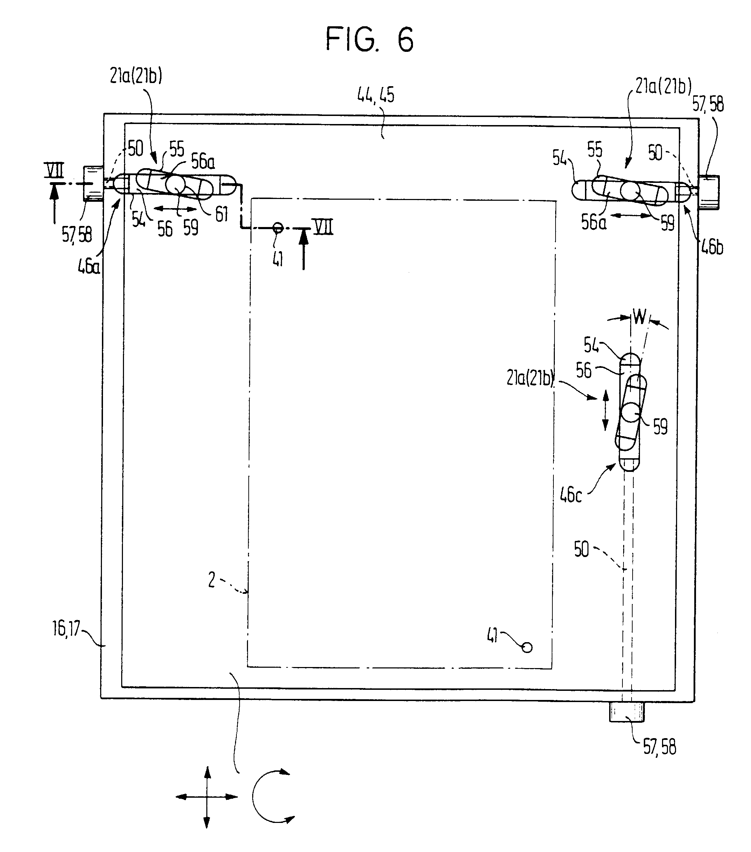

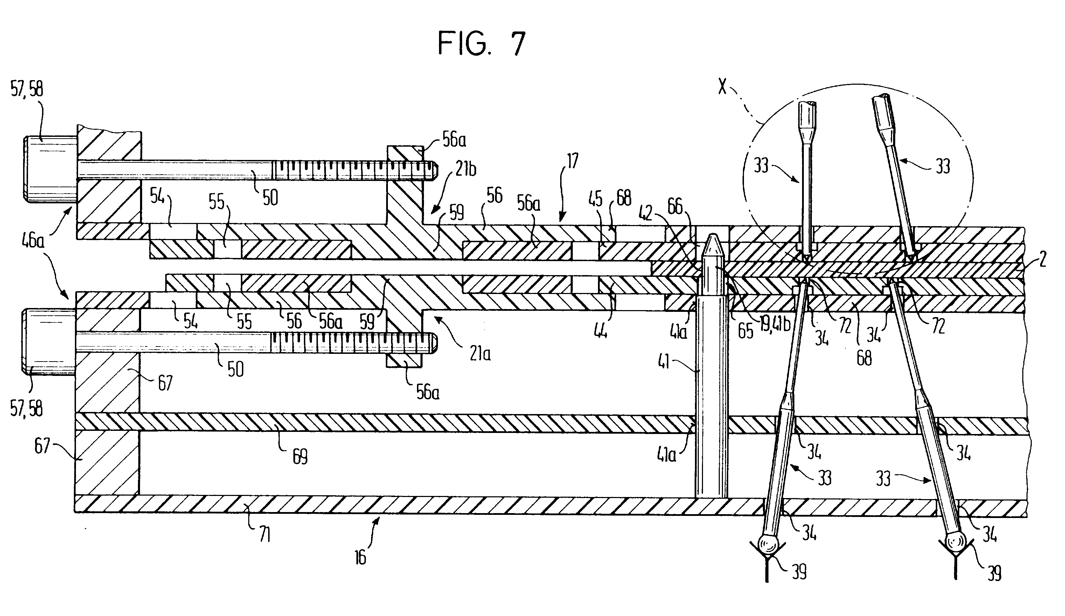

Bei der Ausgestaltung gemäß Fig. 6 und 7 sind die Verstellvorrichtungen 46a, 46b, 46c jeweils durch zwei schräg zueinander verlaufende und übereinander angeordnete Führungsnuten 54, 55 im zu verstellenden Teil und im dieses Teil tragenden, insbesondere flach anliegenden Teil, hier in den Justierplatten 44, 45 und dem zugehörenden Prüfadapter 16, 17 angeordnet. In den Führungsnuten 54, 55 ist ein gemeinsamer Gleitstein 56 in der Längsrichtung einer der beiden Führungsnuten, bei der vorliegenden Ausgestaltung in der Längsrichtung der Führungsnut 54 im zugehörigen Prüfadapter, durch einen Verstellantrieb, z.B. einen den unterseitigen Ansatz 56a am Gleitstein 56 durchfassende Gewindespindel 50 (Spindeltrieb) verstellbar. Der Verstellantrieb kann manuell, z.B. durch eine Handschraube 57 oder maschinell durch einen Motor 58 erfolgen. Die Länge der Führungsnuten 54, 55 ist so lang zu messen, daß die gewünschten translatorischen und rotatorischen Bewegungen im Verstellbereich liegen. Dabei bedarf es einer Drehbarkeit des Gleitsteins 56 in der Führungsnut 55. Diese Drehbarkeit ist dann gewährleistet, wenn der Gleitstein 56 in seinem in die Führungsnut 55 des verstellbaren Teils einfassenden Abschnitt als runder Zapfen ausgebildet ist. In der Führungsnut 54 ist der Gleitstein 56 vorzugsweise ein rechteckförmiges Teil, das flächig an den Gleitflächen anliegt und somit eine linienförmige, verschleißarme Anlage geschaffen ist. Dies kann auch für die Führungsnut 55 verwirklicht werden, wenn der im Querschnitt runde Zapfen 59 im Durchmesser kleiner bemessen ist als die Breite der Führungsnut 55 und in einem besonderen in die Führungsnut 55 passenden rechteckförmigen Gleitstein 56a und eine den Zapfen 59 aufnehmenden Lagerbohrung 61 drehbar gelagert ist. Die Verstellspindel 57 ist durch zwei Gleitschultern oder dgl. an einem festen Teil der Prüfvorrichtung 3, hier am zugehörigen Prüfadapter 16 axial abgestützt, so daß sie die erforderliche axiale Verstellkraft aufzubringen vermag.

Der zwischen den Führungsnuten 54, 55 eingeschlossene Winkel W ist nur so groß, z.B. etwa 10°, zu bemessen, daß keine Selbsthemmung eintritt, sondern das zu verstellende Teil (Justierplatte 44, 45) quer verstellt werden kann.

Die beiden anderen Verstellvorrichtungen 46b, 46c dieser Art sind entsprechend der vorbeschriebenen Ausgestaltung ausgebildet, so daß auf eine besondere Beschreibung verzichtet werden kann. Die Verstellvorrichtung 46b unterscheidet sich von der vorbeschriebenen Verstellvorrichtung 46a lediglich dadurch, daß die Verstellspindel 50 zur anderen Seite des Prüfadapters hin gerichtet ist und somit insbesondere für manuelle Verstellung von der anderen Seite her zugänglich ist.

Die Verstellvorrichtungen 46a, 46b, 46c weisen jeweils einen Abstand voneinander auf und sind vorzugsweise dreieckförmig angeordnet, insbesondere im Randbereich des zu verstellenden Teils, hier der zugehörigen Justierplatte 44, 45.

Die dritte Verstellvorrichtung 46c ist quer, vorzugsweise rechtwinklig zu den Wirkrichtungen (siehe Pfeile) der beiden vorbeschriebenen Verstellvorrichtungen 46a, 46b angeordnet, wobei ihre Verstellspindel 50 zu einer weiteren Seite hin, z.B. die Bedienungsseite manuell zugänglich, verläuft.

Für eine manuelle Verstellung und Justierung ist es vorteilhaft, den Verstellvorrichtungen 46a, 46b, 46c Ableseskalen, z.B. Mikrometerschrauben zuzuordnen, die eine Feineinstellung ermöglichen.

Wie aus dem in Fig. 7 dargestellten Teilschnitt erkennbar, sind die Verstellvorrichtungen 46a, 46b, 46c für die obere Justierplatte 45 bezüglich der horizontalen Leiterplatte 2 spiegelbildlich angeordnet. Von diesen Verstellvorrichtungen ist in Fig. 7 aus Vereinfachungsgründen nur die obere Verstellvorrichtung 46a dargestellt. Die übrigen oberen Verstellvorrichtungen können in spiegelbildlicher Anordnung der vorbeschriebenen Bauweise entsprechen. Im Unterschied zu Fig. 2, bei der ein Abstand zwischen der Leiterplatte 2 und der oberen Justierplatte 45 dargestellt ist, liegt bei der Anordnung gemäß Fig. 7 die obere Justierplatte 45 auf der zu prüfenden Leiterplatte 2 auf. Hierbei handelt es sich um eine Verstellmaßnahme beim Prüfen, auf die weiter unten noch eingegangen wird. Die Fangstifte 41 sind in einem, hier im unteren Prüfadapter 16 in Löchern 41a fest eingesetzt, wobei ihr oberer zylindrischer Endbereich im Querschnitt ggf. verjüngt sein kann und die untere Justierplatte 44 in einem vorzugsweise runden Loch 65 durchfaßt, das im Querschnitt etwas größer bemessen ist als der Querschnitt des oberen Zentrierabschnitts 41b. Hierdurch sind wahlweise Verstellungen (Justierung) der Justierplatte 44 aufgrund des vorhandenen Bewegungsspiels möglich. In der oberen Justierplatte 44 und im oberen Prüfadapter 17 sind Freiraumlöcher 66 vorgesehen, in die die vorzugsweise kegelförmigen oder gerundeten freien Enden der Zentrierabschnitte 41b mit seitlichem Bewegungsspiel hineinragen, so daß eine wahlweise Verstellung und Justierung auch der oberen Justierplatte 45 möglich ist und zwar unabhängig von der Justierung der unteren Verstellplatte 44.

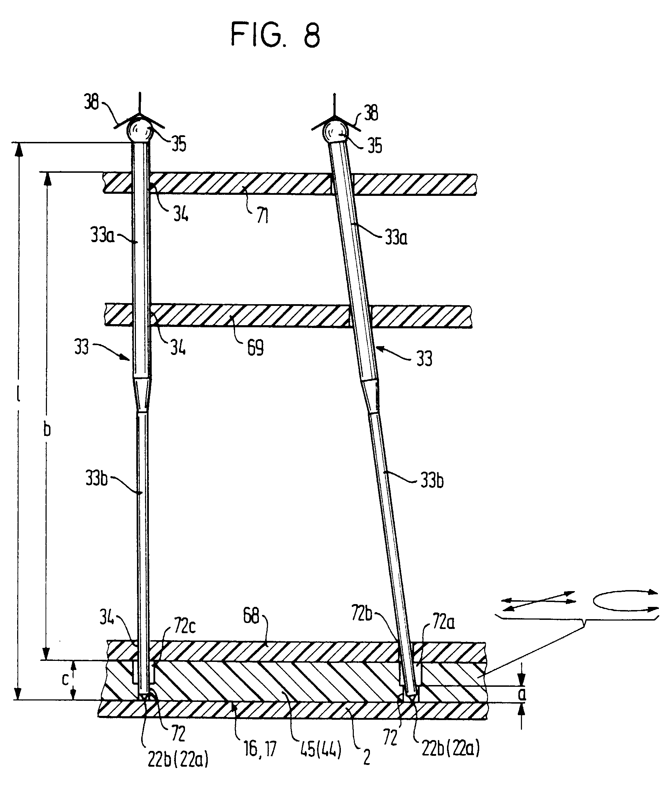

Bei den Prüfadaptern 16, 17 handelt es sich in vorteilhafter Weise um sogenannte Mehrplattenadapter, bestehend aus mehreren, beim vorliegenden Ausführungsbeispiel drei (dargestellt), vier oder auch fünf jeweils in einem Abstand parallel zueinander angeordneten Führungsplatten, die durch am Umfang angeordnete Distanzteile, wie Distanzrahmen oder Distanzleisten 67, voneinander distanziert und befestigt sind. Die Führungsplatten, von denen die der zugehörigen Justierplatte 44, 45 am nächsten liegende und an dieser anliegende Führungsplatte mit 68, die mittlere Führungsplatte mit 69 und die äußere Führungsplatte mit 71 bezeichnet sind, können in unterschiedlichen Abständen voneinander angeordnet sein. Wie aus den Fig. 7 und 8 zu entnehmen ist, verjüngen sich die Prüfstifte 33 zu ihren der Leiterplatte 2 zugewandten Enden hin mit zylindrischen Abschnitten 33a, 33b, die konisch ineinander übergehen. Bei der vorliegenden Ausgestaltung sind zwei Abschnitte unterschiedlichen Durchmessers vorgesehen, wobei die Abschnitte 33a größeren Durchmessers zwei Führungsplatten 69, 71 in den Durchgangs- bzw. Führungslöchern 34 durchfassen, während die zylindrischen Abschnitte 33b geringeren Durchmessers die Führungsplatte 68 in entsprechend kleineren Führungslöchern 34 durchfassen. Bei den Führungslöchern 34 handelt es sich um zylindrische Bohrungen, die vor dem Zusammensetzen bzw. Montieren der Prüfadapter 16, 17 rechtwinklig zu den Führungsplatten 68, 69, 71 eingearbeitet, insbesondere gebohrt sind. Bei einem sich schräg erstreckenden Prüfstift 33 sind daher die zugehörigen Führungslöcher 34 mit einem entsprechend größeren Durchmesser zu bemessen, so daß der Prüfstift 33 an den einander gegenüberliegenden Lochrändern des jeweiligen Lochs 34 mit geringem Bewegungsspiel geführt wird.

Entsprechend sind auch die Führungslöcher 72 in den Justierplatten 44, 45 ausgeführt, d.h., es handelt sich auch hierbei um rechtwinklig zur zugehörigen Justierplatte 44, 45 eingearbeitete, insbesondere eingebohrte Führungslöcher 72, die bei einer schrägen Anordnung des zugehörigen Prüfstifts 33 mit einem entsprechend größeren Durchmesser zu bemessen sind, damit die Prüfstifte 33 sich schräg hindurchstrecken und dabei am oberen und unteren Lochrand geführt werden können. Für eine Zentrierung des Prüfstifts 33 im zugehörigen Führungsloch 72 ist es vorteilhaft, den Durchmesserunterschied so gering wie möglich zu halten, um die Zentrierung zu verbessern. Es ist deshalb vorteilhaft die Länge des Führungslochs 72 auf einen wirksamen Führungsbereich a zu reduzieren. Bei einer vorgegebenen Dicke der Justierplatte 44, 45 kann dieser verjüngte Führungsbereich a durch eine Locherweiterung 72a geschaffen werden, die vorzugsweise auf der Innenseite der Justierplatte 44, 45 angeordnet ist, so daß der Führungsbereich a der Leiterplatte 2 benachbart angeordnet ist. Die Locherweiterung 72a kann auch in die Zentrierung des Prüfstifts 33 einbezogen sein, wenn der Durchmesser so groß bemessen ist, daß der obere Lochrand 72b an der Mantelfläche des Prüfstifts 33 anliegt und diese mit geringem Bewegungsspiel führt. Eine entsprechende Locherweiterung 72c für das Führungsloch 72 kann auch in dem Fall vorgesehen sein, in dem sich der Prüfstift 33 etwa rechtwinklig zur Justierplatte 44, 45 erstreckt, wie es in Fig. 8 links dargestellt ist.

Da die Prüfstifte dünn und somit elastisch biegsam sind, bedarf es nicht eines radialen Bewegungsspiels der Prüfstifte 33 in den Führungslöchern 34 wenigstens in der Führungsplatte 68. Es ist jedoch vorteilhaft, die Führungslöcher 34 wenigstens in der nahen Führungsplatte 34 mit einem so großen Spiel zu bemessen, daß die Prüfenden der Prüfstifte 33 mit der Justierplatte 44, 45 justiert werden können.

Die Länge 1 der Prüfstifte 33 ist etwas größer bemessen als die entsprechende Abmessung b des Prüfadapters 16, 17 einschl. der Dicke c der Justierplatte 44, 45. Infolgedessen weisen die Köpfe 35 einen Abstand vom Prüfadapter 16, 17 auf, wenn die vorzugsweise angespitzten Enden der Prüfstifte 33 an der Leiterplatte 2 bzw. der Prüfpunkten 22a, 22b anliegen.

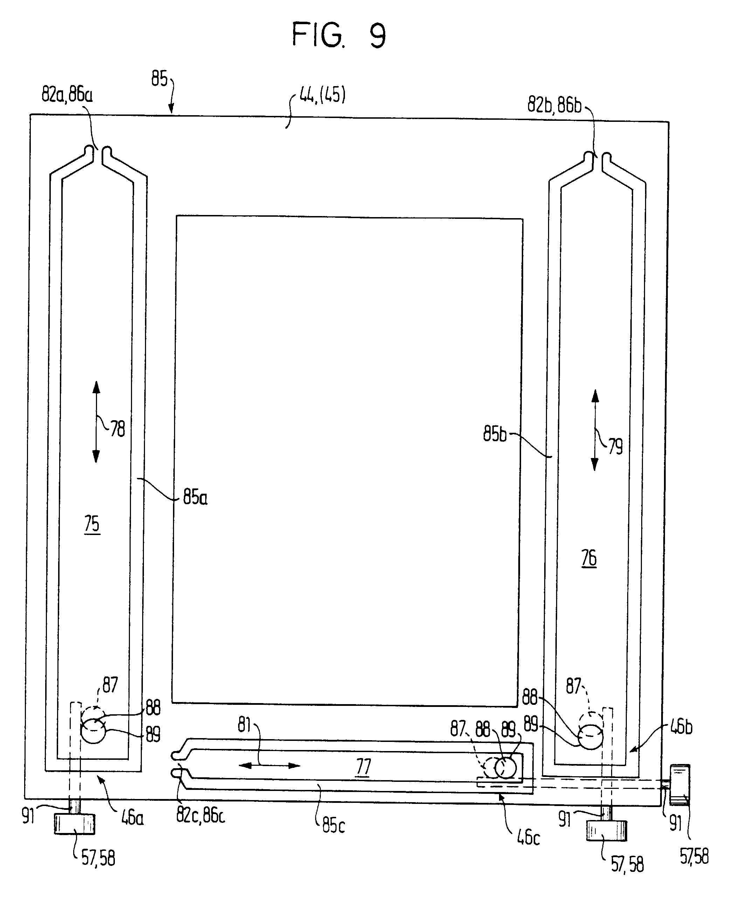

Beim Ausführungsbeispiel der Justiervorrichtung 21a, 21b nach Fig. 9, bei dem gleiche oder vergleichbare Teile mit gleichen Bezugszeichen versehen sind, ist eine Justierplatte 44, 45 besonderer Ausgestaltung und Funktion vorgesehen. Bei dieser Ausgestaltung greifen die Verstellvorrichtungen 46a, 46b, 46c an Teile bzw. Abschnitte 75, 76, 77 der Justierplatte 44, 45 an, die jeweils quer zur Verstellrichtung 78, 79, 81 der zugehörigen Verstellvorrichtung 46a, 46b, 46c nachgiebig bzw. flexibel oder beweglich angeordnet sind. Auf diese Weise gelingt es, quer zur Verstellrichtung 78, 79, 81 gerichtete Antriebsbewegungen im wesentlichen auszuschalten, so daß diese quer gerichteten Antriebsbewegungen zum einen nicht zu Zwängungen führen und zum anderen die Verstellbewegung in die zugehörige Verstellrichtung nicht wesentlich verändern.

Dies kann dadurch erreicht werden, daß die Abschnitte 75, 76, 77 pendelförmig angeordnet und durch Gelenke mit dem zu bewegenden Teil, hier die Justierplatte 44, 45 verbunden sind, die eine quer zur jeweiligen Verstellrichtung 78, 79, 81 gerichtete Bewegung der Abschnitte gestatten, in der Verstellrichtung jedoch unveränderlich mit dem zu verstellenden Teil verbunden sind. Die Abschnitte 75, 76, 77 können durch längliche Schub- und Zugstangen gebildet sein, die biegsam oder jeweils in einem Gelenk 82a, 82b, 82c schwenkbar mit dem zu bewegenden Teil verbunden sind. Bei der vorliegenden Ausgestaltung sind die Abschnitte 75, 76, 77 durch Zungen gebildet, die einstückig aus einer Platine 85 aus Metall oder Kunststoff herausgearbeitet, insbesondere ausgestanzt sind, wobei sie an einem ihrer Enden durch einen verhältnismäßig schmalen Steg 86a, 86b, 86c mit der Platine 85 verbunden sind. Der die jeweilige Zunge umgebende C-förmige Freiraum 85a, 85b, 85c gestattet der Zunge eine Biegung bzw. Auslenkung quer zu ihrer Längsrichtung. Die Verstellvorrichtungen 46a, 46b, 46c greifen in einem Abstand von den Gelenken 82a, 82b, 82c an den Zungen an, vorzugsweise in deren den Gelenken abgewandelten Endbereich. Die Verstellvorrichtungen 46a, 46b, 46c können jeweils durch einen Spindeltrieb gebildet sein, deren Spindelmutter geringfügig schwenkbar mit der zugehörigen Zunge verbunden ist. Bei der vorliegenden Ausgestaltung weisen die Verstellvorrichtungen jeweils einen Exzenterantrieb auf mit einer sich rechtwinklig zur Platine 85 erstreckenden und an der Prüfvorrichtung 3b, am Prüfgerät 13 und/oder an den Prüfadaptern 16, 17 drehbar gelagerten Antriebswelle 87, die mit einem runden exzentrischen Antriebszapfen 88 in ein entsprechend groß bemessenes Loch 89 in der zugehörigen Zunge einfaßt. Durch ein Drehen der Antriebswelle 87 z.B. mittels eines Schneckentriebs mit einer Antriebsspindel 91 läßt sich der exzentrische Antriebszapfen 88 um die Mittelachse der Antriebswelle 87 drehen, wobei er die Platine 85 in der Verstellrichtung 78 verschiebt und gleichzeitig eine Bogenbewegung ausführt, die von der zugehörigen Zunge aufgenommen wird, ohne die Bewegung in der Verstellrichtung 78 wesentlich zu beeinflussen. Die Antriebsspindel 91 kann manuell in Form eines Handrads 57 oder motorisch mittels einem Antriebsmotor 58 angetrieben werden. Insbesondere bei einem manuellen Antrieb ersteckt sich die Antriebsspindel 91 bis zum Umfang des zugehörigen Prüfadapters 16, 17, auf dem die hier eine Justierplatte 44, 45 bildenden Platine 85 definiert mit gewünschten Lateral- und Drehbewegungen um einen beliebigen Punkt, verstellt und justiert werden kann.

Es ist vorteilhaft, zwei der drei Verstellrichtungen 78, 79 parallel zueinander und die dritte Verstellrichtung quer dazu, insbesondere rechtwinklig dazu, anzuordnen. Bei einer quadratischen oder rechteckigen Platine 85 empfiehlt es sich, die Zungen mit den zugehörigen Verstellvorrichtungen 46a, 46b, 46c im Randbereich der Platine bzw. der Justierplatte 44, 45 bzw. des zugehörigen Prüfadapters 16, 17 anzuordnen, und zwar in vergleichbarer Position, wie es beim Ausführungsbeispiel gemäß Fig. 6 bereits beschrieben worden ist.

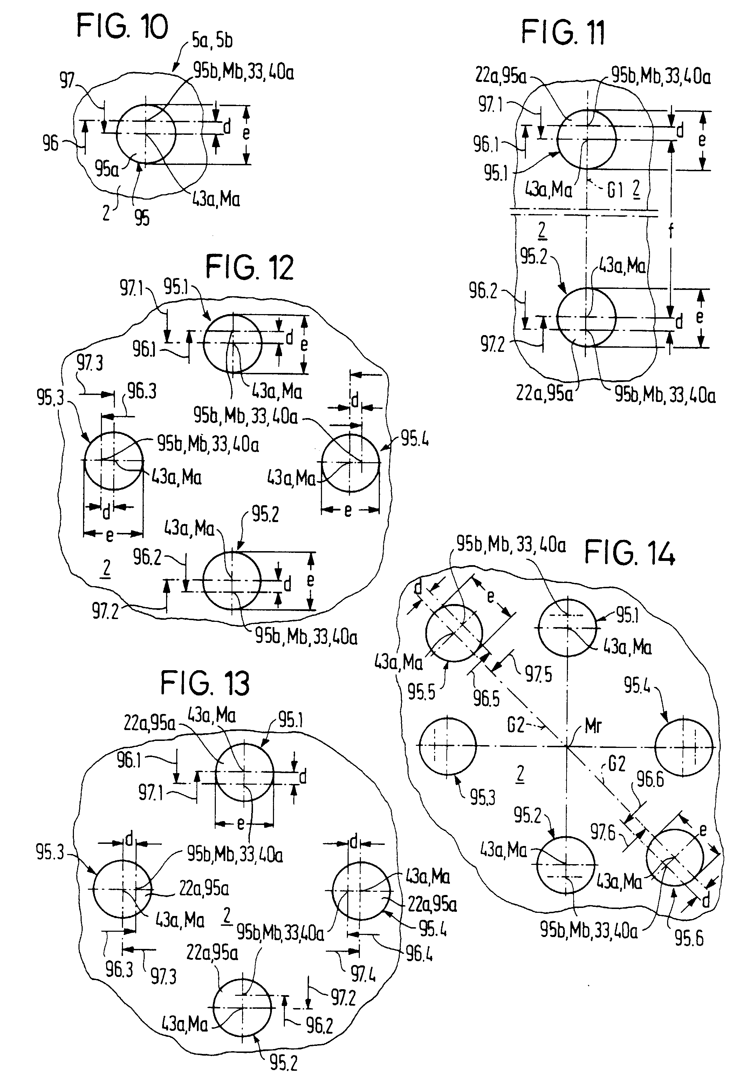

Die zu beiden Seiten der Leiterplatte 2 einander entgegengesetzt angeordneten Vermessungsvorrichtungen 5a, 5b funktionieren in prinzipiell gleicher Weise und sind vorzugsweise auch entsprechend gleich oder spiegelbildlich ausgebildet, so daß die folgende Beschreibung nur der Vermessungsvorrichtung 5b ausreicht, um die Anordnung, Ausgestaltung und Funktion zu verstehen und realisieren zu können. Die Vermessungsvorrichtungen 5a, 5b weisen jeweils ein Kontaktelement-Paar 95 (Fig. 10) mit Kontaktelementen 95a, 95b auf, von denen das Kontaktelement 95a an der Leiterplatte 2 und das Kontaktelement 95b am zugehörigen Prüfadapter 17 angeordnet ist, wobei das Kontaktelement 95a eine viereckige oder runde (dargestellt) Kontaktfläche in der Größe einer Kontaktstelle bzw. eines Prüfpunktes 22a, 22b und das Kontaktelement 95b stiftförmig mit einer Kontaktfläche ausgebildet ist, die im wesentlichen nicht größer bemessen ist als die Kontaktfläche des Kontaktelements 95a. Wesentlich ist, daß die Mittelpunkte Ma, Mb der Kontaktelemente 95a, 95b bei Übereinstimmung des Prüfpunktmusters 43a, 43b und des Prüfstiftspitzenmusters 40a, 40b in einer bestimmten Richtung (Pfeil 96) zueinander versetzt angeordnet sind, wobei das Maß d der Versetzung kleiner, vorzugsweise etwa ein viertel so groß bemessen ist, wie die zugehörige Abmessung e der Kontaktfläche des Kontaktelements 95a. Die Abmessung e kann z.B. etwa 0,1 mm bis 0,5 mm betragen. Bei diesem Ausführungsbeispiel ergibt sich ein Versetzungsmaß d von etwa 0,025 mm bis 0,125 mm. Bei Versuchen hat sich ein Versetzungsmaß von 0,1 mm als vorteilhaft herausgestellt.

Die stiftförmigen Kontaktelemente 95b sind so lang bemessen oder an die Länge der Prüfstifte 33 angepaßt, daß der Kontakt der Kontaktelemente 95a, 95b gleichzeitig mit dem Kontakt der Prüfstifte 33 erfolgt.

Die Versatzrichtung 96 befindet sich in der Richtung, in der hauptsächlich Positionsabweichungen zwischen den Prüfpunktmustern 43a, 43b und den Prüfstiftspitzenmustern 40a, 40b auftreten. Dies kann durch die Fertigungsmaßnahmen vorgegeben sein.

Der vorbeschriebene Mittenversatz ermöglicht eine einfach und schnell durchführbare Feststellung oder Vermessung, ob die vorhandene Positionabweichung zwischen dem Prüfpunktmuster 43a, 43b und dem Prüfstiftspitzenmuster 40a, 40b noch in einem Bereich liegt, in dem die Prüfung der Leiterplatte 2 erfolgen kann, oder ob die Positionsabweichung so groß ist, daß eine Justierung in eine Sollstellung erfolgen soll, in der das Prüfpunktmuster 43a, 43b und das Prüfstiftspitzenmuster 40a, 40b in etwa übereinstimmen. Im zuerst genannten Fall. d.h. dann, wenn eine relativ geringe Positionsabweichung vorhanden ist, kommen die Kontaktelemente 95a, 95b beim Kontaktieren in Kontakt. Durch diesen Kontakt erzeugt die Steuereinrichtung 36a, 37a aufgrund der elektrischen Stromleitung durch den Prüfstift 33 mittels der zugehörigen elektrischen Schaltung ein Signal, daß der Zustand gut ist und die Leiterplattenprüfung durchgeführt werden kann, vorzugsweise automatisch. Im zweiten Fall, d.h. dann, wenn die Positionsabweichung zwischen dem Prüfpunktmuster 43a, 43b und dem Prüfstiftspitzenmuster 40a, 40b relativ groß, d.h. so groß ist, daß die Kontaktelemente 95a, 95b beim Kontaktieren nicht in Kontakt (Stromunterbrechung) kommen, erzeugt die Steuereinrichtung 36a, 37a ein Signal, das zu erkennen gibt, daß eine Justierung in eine Sollstellung erfolgen soll, in der das Prüfpunktmuster 43a, 43b und das Prüfstiftspitzenmuster 40a, 40b kontaktierbar sind und vorzugsweise möglichst genau übereinstimmen. Die Justierung kann dann von Hand oder vorzugsweise automatisch erfolgen. Die Justierbewegung 97 zur Verringerung des Versatzes d ist entgegengesetzt zur Versatzrichtung 96 gerichtet. Aufgrund der bekannten Versatzrichtung 96 kann die das Versatzmaß d verringernde Justierbewegung 97 sowohl bezüglich ihrer Richtung als auch ihrer Größe ermittelt und bestimmt werden. Das Maß der Justierung kann dabei dem Versatzmaß d oder auch etwas mehr entsprechen, um z.B. etwa eine Übereinstimmung der Mitten Ma, Mb herbeizuführen. Das Maß der Justierbewegung 97 kann z.B. der halben Abmessung e (e/2) entsprechen.

Die vorbeschriebene Ausgestaltung mit nur einem Kontaktelement-Paar 95 (Fig. 10) eignet sich dann, wenn von der übereinstimmenden Sollstellung des Prüfpunktmusters 43a, 43b und des Prüfstiftspitzenmusters 40a, 40b eine Positionsabweichung parallel oder insbesondere in der Versatzrichtung 96 vorhanden ist. Dabei kann die Feststellung, ob eine Positionsabweichung vorhanden ist oder nicht, und ob ggf. eine Justierbewegung folgen soll, bei einer einzigen Kontaktierung der Kontaktelemente 95a, 95b erfolgen.

Bei der Ausgestaltung gemäß Fig. 11, bei der gleiche oder vergleichbare Teile mit gleichen Bezugszeichen versehen sind, ist zusätzlich zum vorbeschriebenen Kontaktelement-Paar 95.1 ein zweites Kontaktelement-Paar 95.2 vorzugsweise in einem sich etwa längs der Geraden G1 der Versatzrichtung 96 erstreckenden Abstand f voneinander angeordnet, wobei das zweite Kontaktelement-Paar 95.2 und ggf. noch weitere vorhandene Kontaktelement-Paare gleiche Kontaktelemente 95a, 95b aufweist bzw. aufweisen und wobei letztere Kontaktelemente 95b jedoch in einander entgegengesetzte Richtungen 96.1, 96.2 versetzt sind. Eine solche Ausgestaltung ermöglicht auch dann die Feststellung einer vorhandenen Positionsabweichung innerhalb oder außerhalb eines vorgegebenen Bereiches (gut/schlecht) und ggf. deren Justierung, wenn die Positionsabweichung sich in die entgegengesetzte Richtung, nämlich in die Versatzrichtung 96.2 erstreckt. Die zugehörige Steuereinrichtung 36a, 37a vermag aus der Tatsache, daß das Kontaktelement-Paar 95.1 oder das Kontaktelement-Paar 95.2 bei der Kontaktierung in oder außer Kontakt kommt, mittels einer elektronischen Auswerteschaltung Ca, Cb zu erkennen, ob eine längs der zugehörigen Versatzrichtung 96.1, 96.2 gerichtete Positionsabweichung innerhalb oder außerhalb des zulässigen Bereichs (gut/schlecht) liegt und ggf. ein entsprechendes Signal zu erzeugen und an die Justiervorrichtung 21a, 21b zu leiten, wodurch eine Verstellung und Justierung in der jeweils richtigen Justierrichtung 97.1 bewirkt wird. Dies ist möglich, weil die Steuereinrichtung die jeweilige Versatzrichtung 96.1, 96.2 aufgrund des Kontaktes oder Nicht-Kontaktes des zugehörigen Kontaktelement-Paares 95.1, 95.2 erkennt. Entsprechende Kennungs- und Steuermerkmale sind in die elektrischen Schaltungen der Steuereinrichtung integriert. Auch diese Feststellung einer Positionsabweichung läßt sich durch nur eine Kontaktierung der Kontaktelement-Paare 95.1, 95.2 ermitteln.

Bei der Ausgestaltung nach Fig. 12, bei der gleiche oder vergleichbare Teile ebenfalls mit gleichen Bezugszeichen versehen sind, sind vier Kontaktelement-Paare 95.1, 95.2, 95.3, 95.4 in den Eckpunkten eines Viereckes oder Rechteckes oder Quadrats angeordnet, wobei die Versatzrichtungen 96.1, 96.2, 96.3, 96.4 von einander gegenüberliegenden Kontaktelement-Paaren 95.1, 95.2 oder 95.3, 95.4 einander entgegengesetzt sind und zwar vorzugsweise nach außen gerichtet sind. Wie bereits bei den vorbeschriebenen Ausgestaltungen läßt sich auch bei dieser Ausgestaltung mit einer Kontaktierung der Kontaktelemente-Paare 95.1, 95.2, 95.3, 95.4 ermitteln, ob eine Positionsabweichung zwischen dem Prüfpunktmuster 43a, 43b und dem Prüfstiftspitzenmuster 40a, 40b innerhalb oder außerhalb eines zulässigen Bereichs (gut/schlecht) liegt und in letzterem Fall eine Justierung und somit Korrektur herbeiführen. Auch bei dieser Ausgestaltung vermag die Steuereinrichtung 36a, 37a aus der Tatsache, daß ein, zwei oder drei der vier vorhandenen Kontaktelement-Paare bei einer Kontaktierung in oder außer Kontakt kommt, zu erkennen, ob eine etwa längs den Versatzrichtungen 96.1, 96.2, 96.3, 96.4 gerichtete Positionsabweichung innerhalb oder außerhalb des zulässigen Bereichs (gut/schlecht) liegt und ggf. ein entsprechendes Signal zu erzeugen und an die zugehörige Justiervorrichtung 21a, 21b zu leiten, das eine Verstellung und Justierung in der jeweils richtigen Richtung oder in zwei Richtungen bewirkt. Dies ist auch hier möglich, weil die Steuereinrichtung die jeweiligen Versatzrichtungen 96.1, 96.2, 96.3, 96.4 aufgrund des Kontaktes oder Nicht-Kontaktes der zugehörigen Kontaktelement-Paare erkennt. Auch hier sind entsprechende Erkennungs- und Steuermerkmale in die elektrischen Schaltungen der Steuereinrichtung integriert.

Im Rahmen der Erfindung können beim Vorhandensein von zwei und mehr Kontaktelement-Paaren, die Versatzrichtungen nicht gemäß Fig. 11 und 12 voneinander weg sondern aufeinander zu gerichtet sein, wie es die Fig. 13 beispielhaft zeigt. Dabei ist es im Rahmen der Erfindung auch möglich, daß von mehreren einander gegenüberliegenden Kontaktelement-Paaren der Versatz d von zwei Kontaktelement-Paaren aufeinander zu und der Versatz d von zwei anderen Kontaktelement-Paaren voneinander weg gerichtet ist.

Bei den Positionsabweichungen zwischen dem Prüfpunktmuster 43a, 43b und dem Prüfstiftspitzenmuster 40a, 40b kann es sich nicht nur um vorbeschriebene translatorische Abweichungen handeln, sondern es kann sich auch um rotatorische Positionsabweichungen handeln, die dann vorgegeben sind, wenn das Prüfpunktmuster 43a, 43b relativ zum Prüfstiftspitzenmuster 40a, 40b um einen gedachten Mittelpunkt, der sich innerhalb oder außerhalb der Leiterplatte befinden kann, verdreht ist. Um auch solche rotatorische Positionsabweichungen im erfindungsgemäßen Sinne feststellen und ggf. justieren und somit korrigieren zu können, ist es vorteilhaft, wenigstens einem oder mehreren vorzugsweise vier Kontaktelement-Paaren 95.1, 95.2, 95.3, 95.4 zwei weitere Kontaktelement-Paare 95.5, 95.6 zuzuordnen, deren Mitten Ma, Mb in einander entgegengesetzte Versatzrichtungen 96.5, 96.6 versetzt sind, die jeweils quer oder vorzugsweise in etwa rechtwinklig zu einer Geraden G2 gerichtet sind, die sich durch diese Kontaktelement-Paare 96.5, 96.6 und den gedachten Mittelpunkt Mr erstreckt, um den die rotatorische Positionsabweichung verdreht ist. Eine solche Ausgestaltung ist beispielhaft in Fig. 14 dargestellt, bei der die Kontaktelement-Paare 95.5, 95.6 bezüglich des rotatorischen Mittelpunktes Mr einander gegenüberliegen. Diese Kontaktelement-Paare 95.5, 95.6 können bezüglich des Mittelpunktes Mr jedoch auch einen spitzen bzw. stumpfen Winkel zwischen sich einschließen. Wesentlich ist, daß die Versatzrichtungen 96.5, 96.6 einander entgegengesetzt sind, so daß bei einer rotatorischen Positionsabweichung das eine oder das andere Kontaktelement 95b dieser Kontaktelement-Paare 95.5, 95.6 in oder außer Kontakt mit den zugehörigen Kontaktelement 95a gerät, so daß die zugehörige Steuereinrichtung 36a, 37a im vorbeschriebenen Sinne erkennt, ob die rotatorische Positionsabweichung in oder außerhalb des zulässigen Bereichs (gut/schlecht) liegt und in letzterem Fall eine Justierung und Korrektur der Positionsabweichung im vorbeschriebenen Sinne erfolgen soll, nämlich in Richtung des Pfeiles 97.5 und/oder 97.6, die der Versatzrichtung 96.5, 96.6 etwa entgegensetzt sind, z.B. durch Drehen um die Punkte Ma oder Mr.

Die jeweilige Feststellung und/oder Justierung läßt sich umso genauer durchführen, je mehr Kontaktelement-Paare vorhanden sind. Es ist auch vorteilhaft, die Kontaktelement-Paare in einem möglichst großem Abstand voneinander und somit im Randbereich der Leiterplatte 2 bzw. des Prüfpunktmusters 43a, 43b anzuordnen. Die Anzahl und Position der Kontaktelement-Paare ist so zu bestimmen, daß ihre Versatzrichtungen voneinander abweichen, vorzugsweise quer und einander entgegengesetzt gerichtet sind. Wesentlich ist, daß die Steuereinrichtung 36a, 36b die Richtung des Versatzes d erkennt und das zugehörige Kontaktelement identifiziert. Dies erkennt die zugehörige Steuereinrichtung 36a, 37a aufgrund eines entsprechenden Rechenprogramms, wobei die Versatzpunkte Mb durch ein Hilfsprogramm generiert sein können. Durch ein statistisches Verfahren kann die Richtung ermittelt werden, in der die Justierbewegung zur Korrektur der Positionsabweichung in mehreren Teilbewegungen oder in einer resultierenden Bewegung festgelegt wird, um den Kontakt der Prüfpunkte 22a, 22b mit den Prüfstiften 33 zu gewährleisten und das bestmöglichste Prüfergebnis zu erreichen.

Bei den vorbeschriebenen Ausführungsbeispielen ist der oder sind die stiftförmigen Kontaktelemente 95b um das Versatzmaß d versetzt. Es ist im Rahmen der Erfindung jedoch auch möglich und unter Berücksichtigung verschiedener Ausgestaltungsmerkmale einer vorliegenden Vorrichtung zum Prüfen von Leiterplatten 2 vorteilhaft nicht die stiftförmigen Kontaktelemente 95b, sondern die vorzugsweise durch pads gebildeten Kontaktelemente 95a an der Leiterplatte 2 jeweils um das Versetzungsmaß d in der jeweiligen Versatzrichtung zu versetzen. Im zuerst genannten Fall können handelsübliche Leiterplatten 2 verwendet werden, wobei der oder die Adapter 16 oder 17 mit wenigstens einem um das Versatzmaß d versetzten oder geänderten Kontaktelement 95b auszugestalten ist bzw. sind. Im zweiten Fall können an sich bekannte Adapter verwendet werden, jedoch sind die für die Kontaktelement-Paare vorgesehenen Prüfpunkte 22a, 22b an der Leiterplatte 2 um das Versetzungsmaß d zu versetzen, wodurch eine besondere Ausgestaltung der Leiterplatte vorgegeben ist,

Es ist bei den vorbeschriebenen Ausgestaltungen im Rahmen der Erfindung ferner möglich und vorteilhaft, den oder die stiftförmigen Kontaktelemente 95b durch an sich bekannte oder die vorhandenen Prüfstifte 33 zu bilden, so daß für die Kontaktelemente 95b keine besonderen Stifte hergestellt und gelagert werden müssen. Dies gilt sowohl für den Fall, in dem die stiftförmigen Kontaktelemente 25b bzw. diese bildende Prüfstifte 33 versetzt sind als auch für den Fall, in dem die Kontaktelemente 95a bzw. die betreffenden pads der Leiterplatte 2 versetzt sind.

Bei der vorliegenden Ausgestaltung sind die stiftförmigen Kontaktelemente 95b bzw. die sie bildenden Prüfstifte 33 versetzt. Dies kann dadurch erfolgen, daß die stiftförmigen Kontaktelemente 95b bzw. die sie bildenden Prüfstifte 33 insgesamt seitlich versetzt werden. Dies gilt sowohl für eine vertikale (in grid) oder schräge Anordnung (of grid), siehe Fig. 8. Da es sich bei dem Versatz d um ein geringes Maß handelt, ist es möglich und vorteilhaft, bei einem Mehrplatten-Adapter den Versatz d bei vertikaler oder schräger Anordnung des oder zugehörigen Stifte nur in der die Leiterplatte 2 benachbarten Adapterplatte anzuordnen, hier die entsprechenden Löcher 34 zu versetzen oder so auszubilden, daß deren den Stift seitlich begrenzenden Kanten den Stift in der versetzten Position halten. Beim vorliegenden Ausführungsbeispiel der Prüfvorrichtung mit einer oder zwei Justiervorrichtungen 21a, 21b sind die Löcher 72 in der zugehörigen Justierplatte 44, 45 um das Versatzmaß d versetzt, wobei die Löcher 34 bzw. Lochkanten in der benachbarten Adapterplatte 68 ebenfalls entsprechend versetzt sein können.

Bei allen vorbeschriebenen Ausgestaltungen kommen die Kontaktelemente 95a, 95b der jeweils zugehörigen Kontaktelement-Paare bei der Positionsfeststellung in Kontakt, wenn die Leiterplatte 2 sich im Bereich "gut", d.h. im Sollbereich, befindet. Dabei können die Kontaktelemente 95a, 95b und auch die übrigen Prüfstifte 33 um ein Maß versetzt sein, das durch die Flächengröße der Prüfpunkte bzw. pads vorgegeben ist und bei der runden oder viereckigen oder sonstigen Flächenform kleiner als die Hälfte der Abmessung e ist.

Wenn dagegen die Positionsabweichung so groß wird, daß wenigstens ein Kontaktelement-Paar bei der Kontaktierung außer Kontakt gerät, ist dies ein Merkmal dafür, zu erkennen, welches der zugehörigen Kontaktelemente 95b außer Kontakt ist und außerdem ein Merkmal dafür, die Leiterplatte 2 entgegen der Versatzrichtung dieses Kontaktelements 95b in vorbeschriebener Weise zu justieren und zu korrigieren, damit bei der nachfolgenden Prüfung der Kontaktpunkte der Leiterplatte 2 im wesentlichen Übereinstimmung zwischen dem Prüfpunktmuster 43a, 43b und dem Prüfstiftspitzenmuster 40a, 40b besteht. Wenn bei einer Positionsabweichung und mehr als zwei Kontaktelement-Paaren zwei Kontaktelement-Paare beim Kontaktieren außer Kontakt geraten, z.B. die Kontaktelement-Paare 95.1, 95.3 in Fig. 12, dann läßt sich eine Justierung durch zwei der zugehörigen Versatzrichtung, hier 96.1, 96.2 entgegengesetzte Justierbewegungen, hier 97.1, 97.2, die nacheinander oder durch eine gemeinsame resultierende Bewegung erfolgen können, gewünschte Justierung bzw. Korrektur herbeiführen.

Bei der erfindungsgemäßen Ausgestaltung ist es von Bedeutung, daß es sich bei dem Versatz d nicht um eine in grid- oder of grid-Anordnung der Prüfstifte 33 oder der Prüfpunkte 22a, 22b handelt, sondern es handelt sich um einen besonderen Versatz d, der sowohl bei einer in grid- als auch of grid-Anordnung oder einer sonstigen Anordnung der Prüfstifte 33 und der Prüfpunkte 22a, 22b angeordnet sein kann.

Fig. 3 zeigt eine vorteilhafte Anordnung mehrerer Kontaktelement-Paare, die bezüglich der Feststellung und auch Justierung bzw. Korrektur von translatorischen als auch rotatorischen Positionsabweichungen vorteilhaft ist. Bei dieser Anordnung werden die Kontaktelement-Paare durch die vorhandenen Prüfstifte 33 gebildet, wobei zwei Vierer-Gruppen im Randbereich, insbesondere im Eckenbereich des vorhandenen Prüfpunktmusters angeordnet sind. Dabei haben die Prüfpunkte 22a, 22b bzw. pads eine viereckige Form. Die beiden Gruppen bzw. die vorhandenen Versatzrichtungen 96.1, 96.2, 96.3, 96.4 sind im Unterschied zu Fig. 12 oder 13 um etwa 45° verdreht angeordnet, so daß sie sich etwa parallel zu den Diagonalen der Leiterplatte 2 erstrecken.

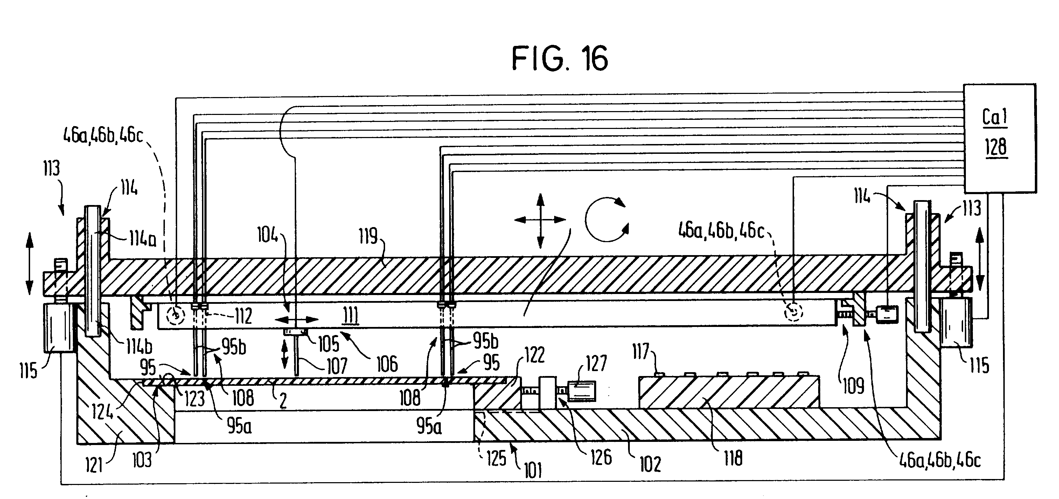

Bei der Ausgestaltung gemäß Fig. 15, bei der gleiche oder vergleichbare Teile ebenfalls mit gleichen Bezugszeichen versehen sind, sind ebenfalls zwei Gruppen von durch Prüfstifte 33 und Prüfpunkten 22a, 22b (pads) gebildete Kontaktelement-Paare vorgesehen, jedoch handelt es sich hierbei um zwei Dreier-Gruppen, z.B. um die Kontaktelement-Paare 95.1, 95.3 und 95.4 aus Fig. 12 oder 13, die bezüglich der Leiterplattenmitte spiegelbildlich angeordnet sind. Auch diese Ausgestaltung eignet sich dazu, sowohl translatorische als auch rotatorische Positionsabweichungen festzustellen und zu korrigieren.

Nachfolgend wird die Funktion der Prüfvorrichtung 3 beschrieben.

Die zu prüfende Leiterplatte 2 gelangt in eine Position des Geräteunterteils 14 und des Geräteoberteils 15 in das Prüfgerät 13, in der sich ein so großer Abstand zwischen den Justierplatten 44, 45 befindet, daß die Leiterplatte 2 auf die Zentrierstifte 41 aufgeschoben und aufgesetzt werden kann. Falls das Geräteoberteil 15 vorher etwas angehoben worden ist, kann es nunmehr in seine Arbeitsstellung heruntergeschwenkt werden. In dieser Position liegen die Prüfstifte 33 mit ihrem Köpfen 35 im oberen Prüfadapter 17 auf diesem auf, wobei die spitzen Prüfenden der Prüfstifte 33 etwas aus der oberen Justierplatte 45 nach unten vorragen. Anschließend wird der Träger 27 hochgeschoben, so daß die Leiterplatte 2 sich gegen die Unterseite der zugehörigen Justierplatte 45 legt, die die oberen Prüfstifte 33 geringfügig in die in Fig. 8 gezeigte Position anhebt und mit ihren Köpfen 35 gegen die Prüfkontakte 39 des Prüfmoduls 37 drückt, die vorzugsweise einfederbar sind. Bei dieser Aufwärtsbewegung des Trägers 27 können auch die Prüfstifte 33 im unteren Prüfadapter 16 gegen die Prüfkontakte 38 des unteren Prüfmoduls 36 gedrückt werden und geringfügig einfedern, wenn ihre Spitzen die Justierplatte 44 geringfügig überragen. Dann kann die Feststellung erfolgen, ob die relative Lage des Prüfpunktmusters 43a, 43b und des Prüfstiftspitzenmusters 40a, 40b im Bereich "gut" liegt, oder eine so große Positionsabweichung vorliegt, daß eine Justierung erforderlich ist, um den Bereich "gut" zu erreichen.

Für den Vorgang "festellen" der Position wird elektrischer Strom durch das oder die Kontaktelement-Paare bzw. die sie bildenden Prüfstifte 33 geleitet und der jeweilige Kontakt oder Nicht-Kontakt gemessen. Beim Zustand "gut" kann sich die Prüfung der Leiterplatte 2 unmittelbar anschließen, wobei elektrischer Strom durch die Prüfstifte 33 geleitet wird. Wenn der Zustand "schlecht" ermittelt wird, erfolgt erst die Justierung in dem Bereich "gut", und dann kann die vorbeschriebene Prüfung der Leiterplatte 2 erfolgen. Danach werden das Geräteoberteil 15 und das Geräteunterteil 14 voneinander distanziert, so daß die Leiterplatte 2 von der Positioniervorrichtung 19 entfernt und weitergeführt werden kann, hier z.B. zur Kennzeichnungsvorrichtung 8 und zur Sortiervorrichtung 9.

Im Rahmen der Erfindung kann die Auswerteschaltung Ca, Cb so ausgebildet sein, daß dann, wenn der beim Kontakt der Kontaktelemente 95a, 95b gemessene Stromwert (niedrigleitender Kontakt) um eine vorbestimmte Größe hinaus von dem Stromwert abweicht, der sich beim Kontakt der Kontaktelemente 95a, 95 in der Sollstellung aufgrund des Versatzes d ergibt (hochleitender Kontakt), der Zustand schlecht und anderenfalls der Zustand gut festgestellt wird.

Die Hauptteile der in Fig. 16 dargestellten Bestückungsvorrichtung 101 sind ein vorzugsweise plattenförmiges Basisteil 102, eine am Basisteil 102 angeordnete Positioniervorrichtung 103 für die Leiterplatte 2, ein der zu bestückenden Seite der Leiterplatte 2 gegenüberliegend angeordnetes BestückungsVorrichtung 104 mit einem Bestückungswagen 105 und einem Bestückungselement, vorzugsweise in Form eines sich vom Bestückungswagen 105 rechtwinklig zur Leiterplatte 2 erstreckenden Bestückungsstiftes 106, einem FührungsVorrichtung 106 für den Bestückungswagen 105, in dem der Bestückungswagen 105 mit dem Bestückungsstift 107 wahlweise zu jeder gewünschten Kontaktinsel (pad) durch einen nicht dargestellten Antrieb verfahrbar und in der jeweiligen Fahrstellung feststellbar ist, eine Feststell- oder Vermessungsvorrichtung 108 zum Prüfen bzw. Feststellen, ob sich die Leiterplatte 2 mit ihren Prüfpunkten bzw. Kontaktinseln 22a bezüglich des FührungsVorrichtungs 106 und den jeweiligen Bestückungsstellungen des Bestückungsstiftes 107 in der zugehörigen ausgerichteten Stellung befindet oder von dieser korrekten Stellung über ein bestimmtes Maß abweicht, und eine Justiervorrichtung 109, zum Korrigieren dieser Abweichung soweit, daß die Kontaktinseln 22a bezüglich den durch das FührungsVorrichtung 106 vorgegebenen Bestückungsstellungen des Bestückungsstiftes 107 sich in der ausgerichteten Stellung oder einer Stellung befinden, in der die Abweichung unschädlich ist.

Die Feststell- oder Vermessungsvorrichtung 108 weist wenigstens ein, vorzugsweise mehrere Kontaktelement-Paare 95, 95.1 bis 95.6 gemäß den vorbeschriebenen Ausführungsbeispielen auf, wobei das oder die der Leiterplatte 2 zugeordneten Kontaktelemente durch besondere Kontaktinseln 22a oder solche Kontaktinseln 22a gebildet sein können, die zum BestückungsVorrichtung gehören, im vorliegenden Fall jedoch nicht zum Bestücken gebraucht werden. Auf die vorbeschriebene Kontaktelement-Paare mit der oder dem Versatzmaßen d und Versatzrichtungen 96.1 bis 96.6 und der Anordnung zugehöriger Kontaktinseln 22a auf der Leiterplatte 2, siehe z.B. Fig. 3 und 15, wird im vollen Umfang Bezug genommen, so daß es einer wiederholenden Beschreibung nicht bedarf. Bei der vorliegenden Ausgestaltung sind die stiftförmigen Kontaktelemente 95b an einem das FührungsVorrichtung 106 enthaltenden, insbesondere plattenförmigen Führungsteil 111 gehalten, z.B. in passenden Aufnahmelöchern 112 im Führungsteil 111, wobei die Kontaktelemente 95b rechtwinklig zur Leiterplatte 2 zu dieser vorragen und in einem geringen Abstand davon enden. Bei den in Fig. 16 dargestellten Kontaktelementen 95b kann es sich um zwei Dreier- oder Vierer-Gruppen handeln, die Kontaktelementen 95a entsprechender Anordnung, hier Dreier- oder Vierer-Gruppen gemäß Fig. 3 und 15 um das Besetzungsmaß d versetzt gegenüberstehen.

Des weiteren weist die Bestückungsvorrichtung 101 eine Kontaktiervorrichtung 113 auf, mit der die Kontaktelement-Paare 95 relativ zueinander in Kontakt und wieder außer Kontakt gebracht werden können. Bei der Ausgestaltung gemäß Fig. 16 sind die Kontaktelemente 95b rechtwinklig zur Leiterplatte 2 verstellbar, wobei diese Verstellbewegung in einer Führung 114 und durch einen Antrieb mit einem Antriebsmotor 115 erfolgt.

Bei der Justiervorrichtung 109 kann es sich um eine solche gemäß den vorbeschriebenen Ausführungsbeispielen nach Fig. 2 bis 6 und 9 handeln. Auf die zugehörigen Beschreibungen wird in vollem Umfang Bezug genommen, so daß eine wiederholende Beschreibung entfallen kann. Wesentlich ist, daß die Justiervorrichtung 109 in der Horizontalen translatorische und/oder rotatorische Bewegungen für die Kontaktelemente 95b und somit eine Sollposition zwischen den Kontaktelementen 95a und den möglichen Bestückungsstellungen des Bestückungsstiftes 107 erzeugen kann, in der eine hinreichend genaue Bestückung möglich ist.

Der Bestückungsstift 107 ist mittels eines nicht dargestellten Antriebs in seiner Längsrichtung, d.h. quer zur Leiterplatte 2, verstellbar und in der jeweiligen Verstellposition verstellbar, um wenigstens eine in Fig. 16 andeutungsweise dargestelltes elektronisches Bauelement 117 ergreifen und in der jeweiligen Bestückungsposition an die Leiterplatte 2 ansetzen zu können.

Bei der vorliegenden Ausgestaltung befindet sich das Basisteil 102 mit der daran positionierten Leiterplatte 2 in horizontaler Anordnung. Im Rahmen der Erfindung ist es möglich und aus rationellen Gründen vorteilhaft, die Bestückungsvorrichtung 101 so bezüglich der hier horizontalen Leiterplatte 2 spiegelbildlich zu vervollständigen, daß die Leiterplatte 2 von beiden Seiten mit elektronischen Bauelementen 117 bestückt werden kann.

Vorzugsweise ist der Bestückungsvorrichtung 101 ein Magazin 118 bezüglich der Leiterplatte 2 in vorzugsweise seitlicher Position zugeordnet, in dem elektronische Bauelemente 117 als Vorrat bereitgestellt werden können. Die Höhenposition der Bauelemente 117 entspricht dabei in etwa der Höhenposition der zu bestückenden Seite der Leiterplatte 2. Entsprechend groß ist das FührungsVorrichtung 105 ausgelegt, so daß der Laufwagen 105 auch die verschiedenen Entnahmepositionen am Magazin 118 erreichen kann.

Bei der vorliegenden Ausgestaltung ist das das FührungsVorrichtung 105 enthaltende Führungsteil 111 an einem brückenförmigen Träger 119 gehalten, der am Basisteil 102 in einer die Leiterplatte 2 und das Magazin 118 überbrückenden Position gehalten ist. Des weiteren werden bei der Ausgestaltung gemäß Fig. 16 mittels der Justiervorrichtung 109 die Kontaktelemente 95b zwecks Korrektur der Abweichung von der Sollposition verstellt. Dies kann dadurch erfolgen, daß das Führungsteil 111 in die Justiervorrichtung 109 integriert ist und die Verstellvorrichtungen 46a, 46b, 46c auf das Führungsteil 111 wirken und letzteres mit den Kontaktelementen 95b justieren. Die Führung 114 ist durch zu beiden Seiten angeordnete zwei am Basisteil 102 befestigte vertikale Führungsstangen 114a gebildet, die Führungsbohrungen 114b im Träger 119 durchfassen.

Die Positioniervorrichtung 103 wird bei der vorliegenden Ausgestaltung durch zwei Spannbacken 121, 122 am Basisteil 102 gebildet, die jeweils eine Auflagefläche 123 zur Auflage der Leiterplatte 2 und eine Spannfläche 124 zum Spannen der Leiterplatte 2 an ihrem Umfang aufweist. Die Spannbacke 122 ist in einer parallel zur Leiterplatte 2 gerichteten Führung 125 hin und her verschiebbar gelagert. Mittels einer Verstellvorrichtung 126, z.B. ein Spindeltrieb mit einem Antriebsmotor 127, läßt sich die Spannbacke 122 wahlweise gegen die Leiterplatte 2 spannen und lösen.

Im weiteren ist der Bestückungsvorrichtung 101 auch eine elektronische Steuereinrichtung 128 mit einer elektronischen Auswerteschaltung Ca1 zugeordnet, die durch elektrische Steuerleitungen mit den Kontaktelementen 95b und den Antriebsmotoren der Justiervorrichtung 109 und der Kontaktiervorrichtung 113 und ggf. auch mit dem Antriebsmotor 127 der Spannvorrichtung 126 sowie ggf. auch mit der Leiterplatte 2 verbunden ist.

Im folgenden wird die Funktion der Bestückungsvorrichtung 101 beschrieben.

Nach dem Einlegen und Positionieren der Leiterplatte 2 in der Positioniervorrichtung 103 erfolgt die Prüfung und Feststellung, ob die Leiterplatte sich im Bereich einer akzeptablen Positionsabweichung, nämlich im Positionsbereich "gut" oder im Bereich einer unakzeptablen Positionsabweichung, im Positionsbereich "schlecht", befindet. Hierzu wird die Kontaktiervorrichtung 113 eingeschaltet, wobei bei der vorliegenden Ausgestaltung der Träger 119 mit dem Führungsteil 111 und den Kontaktelementen 95b mittels des Antriebs 115 in der Führung 114 abgesenkt wird, wobei die Kontaktelemente 95b die Kontaktelemente 95a kontaktieren. Mittels der Auswerteschaltung Cal werden die elektrischen Stromwerte an den Kontaktstellen der Kontaktelement-Paare 95 usw. gemessen und es wird festgestellt, ob die Leiterplatte 2 sich im Sollbereich, d.h. im Bereich "gut" befindet oder nicht. Im ersten Fall kann ggf. nach Wiederanhebung der Kontaktelemente 95b die Bestückung erfolgen. Im zweiten Fall erfolgt ggf. nach Wiederanhebung eine Korrektur der Relativposition zwischen der Leiterplatte 2 und den Kontaktelementen 95b, hier durch Justieren der Kontaktelemente 95b mittels der Justiervorrichtung 109 in der bereits beschriebenen Weise. Danach kann die Bestückung der Leiterplatte 2 mit den Bauelementen 117 in an sich bekannter Weise erfolgen.

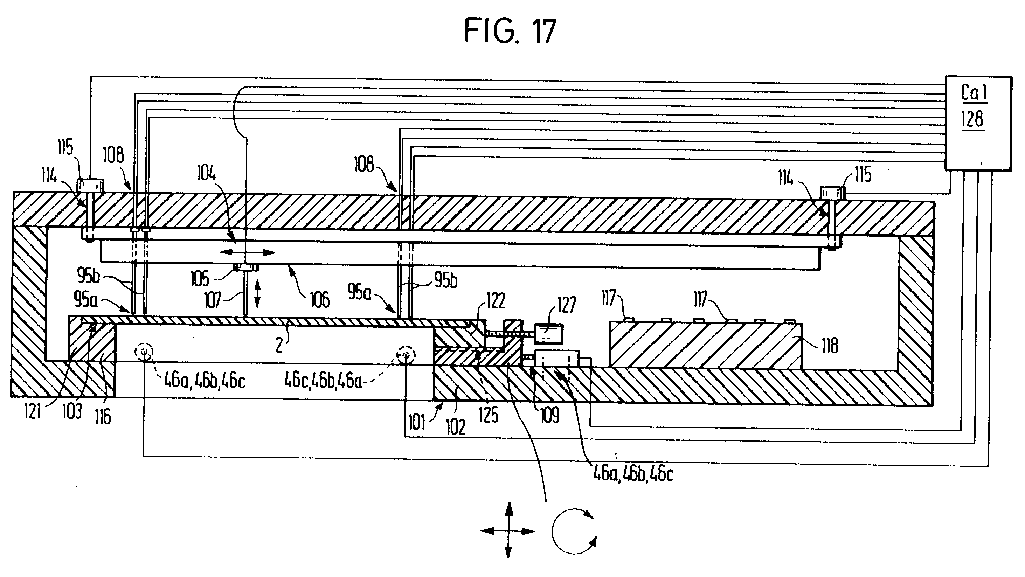

Das Ausführungsbeispiel nach Fig. 17, bei dem gleiche oder vergleichbare Teile mit gleichen Bezugszeichen versehen sind, unterscheidet sich von der vorbeschriebenen Ausgestaltung im wesentlichen nur dadurch, daß zum einen die Positioniervorrichtung 109 der Positioniervorrichtung 103 zugeordnet oder in diese integriert ist und zum anderen die Kontaktiervorrichtung 113 nicht zwischen dem Basisteil 102 und dem Träger 119 sondern zwischen letzterem und dem Führungsteil 111 wirksam sind. Der Träger 119 ist fest auf aufrechten Stützteilen des Basisteils 102 angeordnet. Auch bei dieser Ausgestaltung der Kontaktiervorrichtung 113 ist ein genaues Absenken der Kontaktelemente 95b in einer jeweils durch eine Führungsbohrung und eine darin angeordnete Führungsstange sowie eine Schub- und Zugstange gewährleistet. Bei dieser Ausgestaltung können die Verstellvorrichtungen 46a, 46b, 46c an einer die Leiterplatte 2 tragenden Justierplatte 116 angreifen.

Die Verfahrensschritte zum Prüfen und Feststellen sowie ggf. Justieren der Leiterplatte 2, hier der Leiterplatte 2 direkt, erfolgen entsprechend der vorbeschriebenen Verfahrensweise.

## Patentansprüche

1. Vorrichtung (3) zum Prüfen einer Kontaktinseln (22a,22b) und Leiterbahnen aufweisenden elektrischen Leiterplatte (2), mit einem Prüfadapter (16, 17) mit Prüfstiften (33), die sich zwischen Prüfkontakten (39) eines Leiterplatten-Prüfgerätes (13) und den Kontaktinseln (22a, 22b) der zu prüfenden Leiterplatte (2) erstrecken,
**dadurch gekennzeichnet,**
daß eine Justiervorrichtung (21a, 21b) vorgesehen ist zum Justieren bzw. Feinverstellen der Prüfstifte (33) und/oder des Prüfadapters (16, 17) und/oder der Leiterplatte (2) quer zu den Prüfstiften (33) und zum Feststellen in der eingestellten Position.

2. Vorrichtung nach Anspruch 1,
**dadurch gekennzeichnet,**
daß die Justiervorrichtung (21a, 21b) in einer Ebene drei Bewegungsfreiheiten hat, nämlich zwei Translationen und eine Rotation.

3. Vorrichtung nach Anspruch 1 oder 2,
**dadurch gekennzeichnet,**
daß die Justiervorrichtung (21a, 21b) drei Verstellvorrichtungen (46a, 46b, 46c) aufweist, die in einem Abstand voneinander am zu verstellenden Teil angreifen und beweglich, insbesondere schwenkbar mit dem zu verstellenden Teil verbunden sind.

4. Vorrichtung nach einem der vorherigen Ansprüche,
**dadurch gekennzeichnet,**
daß die Verstellrichtungen (78, 79) von zwei Verstellvorrichtungen (46a, 46b) etwa parallel zueinander gerichtet oder geringfügig zueinander geneigt sind und die Verstellrichtung (81) der dritten Verstellvorrichtung (46c) quer dazu gerichtet ist.

5. Vorrichtung nach einem der vorherigen Ansprüche,
**dadurch gekennzeichnet,**
daß die Verstellvorrichtung (46a, 46b, 46c) jeweils eine längenveränderliche Schub- und Zugstange (27a, 27b, 27c) aufweisen, die an beiden Enden in der Verstellebene schwenkbar angelenkt sind.

6. Vorrichtung nach einem der vorherigen Ansprüche,
**dadurch gekennzeichnet,**
daß die Verstellvorrichtungen (46a, 46b, 46c) jeweils einen kniehebelförmigen Verstellarm (51a, 51b, 51c) aufweisen, der beidhändig in der Verstellebene schwenkbar in Gelenken (48a, 48b, 48c, 48d, 48e, 48f) schwenkbar gelagert sind, von denen jeweils einem Gelenk (48a, 48b, 48c) jeweils ein Antrieb (53a, 53b, 53c) zugeordnet ist.

7. Vorrichtung nach einem der vorherigen Ansprüche,
**dadurch gekennzeichnet,**
daß die Verstellvorrichtungen (46a, 46b, 46c) jeweils einen verschiebbar angetriebenen Gleitstein (56a) aufweisen, der in zwei einander mit einem spitzen Winkel (W) kreuzenden Nuten (54, 55) verschiebbar ist, die in Teilen der Justiervorrichtung (21a, 21b) angeordnet sind.

8. Vorrichtung nach einem der vorherigen Ansprüche,
**dadurch gekennzeichnet,**
daß die Verstellvorrichtungen (46a, 46b, 46c) jeweils ein längliches Schub- und Zugelement (75, 76, 77) aufweisen, das an seinem einen Endbereich in der Verstellebene schwenkbar mit dem zu verstellenden Teil verbunden ist und in einem Abstand davon mit einem Antriebselement (87) verbunden ist.

9. Vorrichtung nach Anspruch 8,
**dadurch gekennzeichnet,**
daß das zu verstellende Teil eine Platine ist und die stangenförmigen Schub- und Zugelemente (75, 76, 77) innerhalb eines C-förmigen Freiraums (85a, 85b, 85c) aus der Platine einstückig ausgearbeitet insbesondere gestanzt und durch einen biegsamen Verbindungssteg (86a, 86b, 86c) einstückig mit der Platine (85) verbunden ist.

10. Vorrichtung nach einem der vorherigen Ansprüche,
**dadurch gekennzeichnet,**
daß zu beiden Seiten der Leiterplatte (2) eine Justiervorrichtung (21a, 21b) zum Justieren des zugehörigen Prüfadapters (16, 17) oder der zugehörigen Prüfstifte (33) zur voneinander unabhängigen Prüfung der Prüfpunkte (22a, 22b) auf beiden Seiten der Leiterplatte (2) vorgesehen sind.

11. Vorrichtung nach einem der vorherigen Ansprüche,
**dadurch gekennzeichnet,**
daß die Justiervorrichtung (21a, 21b) zur Justierung der Adapterstifte (33) eine mit den Verstellvorrichtungen (46a, 46b, 46c) verbundene Justierplatte (44, 45) ist, durch die sich die Prüfenden der Prüfstifte (33) in passenden Justierlöchern (72) erstrecken.

12. Vorrichtung nach Anspruch 11,
**dadurch gekennzeichnet,**
daß die Justierplatte (44,45) ein Teil des Prüfadapters (16, 17) ist.

13. Vorrichtung nach Anspruch 11 oder 12,
**dadurch gekennzeichnet,**
daß die Justierplatte (44, 45) in dem der Leiterplatte (2) zugewandten Endbereich des Prüfadapters (16, 17) angeordnet ist.

14. Vorrichtung nach einem der vorherigen Ansprüche,
**dadurch gekennzeichnet,**
daß die Justierplatte (44, 45) an der der Leiterplatte (2) zugewandten Seite des Prüfadapters (16, 17) vorzugsweise anliegend angeordnet ist.

15. Vorrichtung nach Anspruch 14,
**dadurch gekennzeichnet,**
daß zumindest während des Prüfvorgangs die Justierplatte (44, 45) zwischen dem Prüfadapter (16, 17) und der Leiterplatte (2) an diesen anliegend angeordnet ist.

16. Vorrichtung nach einem der vorherigen Ansprüche,
**dadurch gekennzeichnet,**
daß wenigstens einer der beiden Prüfadapter (16, 17), vorzugsweise beide Prüfadapter (16, 17), quer zur Leiterplatte (2), insbesondere vertikal verstellbar sind.

17. Vorrichtung nach einem der vorherigen Ansprüche,
**dadurch gekennzeichnet,**
daß der oder die Prüfadapter (16, 17) jeweils durch einen Mehrplattenadapter gebildet ist bzw. sind.

18. Vorrichtung nach einem der vorherigen Ansprüche,
**dadurch gekennzeichnet,**
daß die Prüfstifte (33) im Prüfadapter (16, 17), insbesondere in der Leiterplatte (2) zugewandten Endbereich des Prüfadapters, oder in dessen Leiterplatte (2) zugwandten Platte (68) mit geringem radialen Bewegungsspiel in den Führungslöchern (34) des Prüfadapters aufgenommen sind.

19. Vorrichtung nach einem der vorherigen Ansprüche,
**dadurch gekennzeichnet,**
daß die wirksame Länge der Justierlöcher (72) in der Justierplatte (44, 45) durch Locherweiterungen (72a) auf eine Länge (a) verringert ist, die kleiner ist, als die Dicke (c) der Justierplatte (44, 45).

20. Prüfadapter für eine Vorrichtung zum Prüfen oder Bestücken einer Prüfpunkte bzw. Kontaktinseln 22a,22b) und Leiterbahnen aufweisenden elektrischen Leiterplatte (2),
**dadurch gekennzeichnet,**
daß der Prüfadapter (16, 17) nach einem der vorherigen Ansprüche 1 bis 19 ausgebildet ist.

21. Justiervorrichtung für eine Vorrichtung zum Prüfen oder Bestücken einer Prüfpunkte bzw. Kontaktinseln (22a, 22b) und Leiterbahnen aufweisenden elektrischen Leiterplatte,
**dadurch gekennzeichnet,**
daß Justiervorrichtung (21a, 21b) nach einem der vorherigen Ansprüche 1 bis 19 ausgebildet ist.

22. Verfahren zum Prüfen einer Prüfpunkte bzw. Kontaktinseln (22a,22b) und Leiterbahnen aufweisenden elektrischen Leiterplatte (2) bezüglich der Position der Leiterplatte (2) bzw. ihrer Prüfpunkte bzw. Kontaktinseln (22a, 22b) relativ zu den Prüfstiften (33) eines Prüfadapters (16, 17),
- wobei eine Überprüfung oder eine optische Vermessung der Position der Leiterplatte (2) in einer ersten besonderen Arbeitsstation erfolgt,
- wobei die Leiterplatte (2) nach ihrer Vermessung einem Prüfgerät (13) zum Prüfen der Kontaktinseln (22a, 22b) der Leiterplatte (2) in einer zweiten besonderen Arbeitsstation zugeführt wird,
- und Positionsabweichungen der Leiterplatte (2) von der korrekten Position im Prüfgerät (13) mittels einer Justiervorrichtung (21a, 21b) dadurch justiert werden,
- daß die Prüfenden der Prüfstifte (33) mittels der Justiervorrichtung (21a, 21b) quer zu den Prüfstiften (33) verschoben werden.
